# EUROPÄISCHE PATENTSCHRIFT

(11) **EP 2 042 881 B1**
(45) Veröffentlichungstag und Bekanntmachung des Hinweises auf die Patenterteilung: **13.04.2011**
(21) Anmeldenummer: 07019151.5
(22) Anmeldetag: 28.09.2007
(51) Int. Cl.: G01R 33/3415, G01R 33/345

(54) **Streifenleiter-Antenne und Antennenanordnung für ein Magnetresonanzgerät**
Stripline antenna and antenna assembly for a magnetic resonance device
Antenne et agencement d'antenne à ligne ruban pour un appareil à résonance magnétique

(43) Veröffentlichungstag der Anmeldung: 01.04.2009
(73) Patentinhaber: Max-Planck-Gesellschaft zur Förderung der Wissenschaften e.V., 80539 München (DE)
(72) Erfinder: Driesel, Wolfgang, 06792 Sandersdorf (DE); Möller, Harald, 04107 Leipzig (DE)
(74) Vertreter: Hertz, Oliver

(56) Entgegenhaltungen:
- WO-A-2005/076029
- WO-A-2005/111645
- WO-A-2006/113545
- US-A1- 2005 024 054
- US-A1- 2005 162 168
- US-A1- 2007 080 768
- JONES A ET AL: "Quadrature strip-line surface coil for ultra-high field imaging (7T)" PROCEEDINGS OF THE INTERNATIONAL SOCIETY FOR MAGNETIC RESONANCE IN MEDICINE, JOINT ANNUAL MEETING ISMRM-ESMRMB, 19-25 MAY 2007, BERLIN, GERMANY, 19. Mai 2007 (2007-05-19), Seite 1065, XP002470651
- VAUGHAN JT ET AL: "Detunable transverse electromagnetic (TEM) volume coil for high-field NMR" MAGNETIC RESONANCE IN MEDICINE, Bd. 47, 2002, Seiten 990-1000, XP002470652

## Beschreibung

### Gegenstand der Erfindung

Die Erfindung betrifft eine Antenne für ein Magnetresonanzgerät (MR-Gerät), insbesondere eine Antenne mit den Merkmalen des Oberbegriffs von Anspruch 1. Die Erfindung betrifft des Weiteren eine Antennenanordnung für ein MR-Gerät und ein Verfahren zum Betrieb des MR-Gerätes. Die Hauptanwendung der Erfindung besteht in der Magnetresonanz-Bildgebung (MR-Bildgebung, magnetic resonance imaging, MRI) und in der Magnetresonanz-Spektroskopie.

### Stand der Technik

Die magnetische Kernresonanz hat sich als ein wichtiges Bildgebungs- und Analyseverfahren, insbesondere in der Medizin, etabliert. Hierbei wird ausgenutzt, dass magnetische Kernmomente im statischen Magnetfeld bei Einstrahlung elektromagnetischer Energie einer definierten Frequenz ausgelenkt werden können. Die Frequenz bestimmt sich aus der Stärke des statischen Magnetfeldes und der gyromagnetischen Konstante der untersuchten Atomkerne. Die infolge der Anregung kohärent präzedierenden Kernmomente erzeugen ein magnetisches Induktionssignal, das mit geeigneten Spulen registriert und zur Rekonstruktion eines Bildes genutzt werden kann. Grundsätzlich können dieselben Spulen sowohl zum Anregen, also Senden eines Hochfrequenz-(HF-)Signals, als auch zum Empfang genutzt werden. Da das Signal von Spulen im Nahfeld um so stärker und inhomogener wird, je näher man dem Leiter der HF-Spule kommt, hat man zuerst oft mit so genannten Volumenspulen relativ homogen HF-Energie in das zu untersuchende Volumen eingestrahlt und kleine Oberflächenspulen zum Empfang benutzt. Im Vergleich zum Empfang mit Volumenspulen kann man dabei das Signal-zu-Rausch-Verhältnis (signal-to-noise ratio, SNR) beträchtlich steigern. Allerdings engt man auch das Gesichtsfeld (field of view, FOV) stark ein.

Seit etwa 1990 werden zur Erhöhung des SNR in spulennahen Bereichen Antennenarrays verwendet, die aus mehreren einzelnen Spulen (im Weiteren Antennen genannt) zusammengesetzt sind (siehe z. B. Roemer PB, Edelstein WA. Nuclear magnetic resonance (NMR) imaging with multiple surface coils. US 4,825,162 1; Roemer PB, Edelstein WA, Hayes CE, Souza SP, Mueller OM. The NMR phased array. Magn. Reson. Med. 1990; 16(2): 192-225; Lian J, Roemer PB. MRI RF coil. US 5,804,969). Die ersten Arrays bestanden aus mehreren Antennen, die meistens eben und teilweise überlappt angeordnet waren. Durch die teilweise Überlappung der benachbarten Antennen gelang es, die induktive Kopplung zwischen diesen Antennen zu minimieren. Da dieses Prinzip der Entkopplung nur auf benachbarte Antennen anwendbar ist, nutzte man im Empfangsfall zusätzlich noch das Prinzip der Vorverstärkerentkopplung zur Minimierung der Kopplung zwischen den Arrayelementen.

In der Folgezeit wurden Arrays für unterschiedliche Anwendungen optimiert. Sie unterschieden sich insbesondere nach der geometrischen Anordnung der Antennen. So sind Arrays bekannt, bei denen die Teilspulen längs einer Linie (siehe z. B. Bankson JA, Griswold MA, Wright SM, Sodickson DK. SMASH imaging with an eight element multiplexed RF coil array. Magn. Reson. Mater. Phys. Biol. Med. 2000; 10: 93-10) oder gitterförmig in einer Fläche (siehe z. B. Hardy CJ, Darrow RD, Saranathan M, Giaquinto R, Zhu Y, Dumoulin CL, Bottomley PA. Large fieldof-view real-time MRI with a 32-channel system. Magn. Reson. Med. 2004; 52: 878-884) angeordnet sind. Zur besseren Anpassung der Arrays an die Form der Untersuchungsobjekte entwickelte man auch Anordnungen auf dem Mantel eines Zylinders (siehe z. B. de Zwart JA, Ledden PJ, Kellman P, van Gelderen P, Duyn JH. Design of a SENSE-optimized high-sensitivity MRI receive coil for brain imaging. Magn. Reson. Med. 2002; 47(6): 1218-1227; de Zwart JA, Ledden PJ, van Gelderen P, Bodurka J, Chu RX, Duyn JH. Signal-to-noise ratio and parallel imaging performance of a 16-channel receive-only brain coil array at 3.0 Tesla. Magn. Reson. Med. 2004; 51(1): 22-26).

Beim "klassischen" Arraydesign werden ausschließlich Magnetfeld-Gradienten für die Kodierung der Ortsinformation genutzt, und die Verbesserung des SNR im FOV steht im Vordergrund. Nach den ersten Arbeiten zur Parallelbildgebung (siehe z. B. Pruessmann KP, Weiger M, Scheidegger MB, Boesiger P. SENSE: Sensitivity encoding for fast MRI. Magn. Reson. Med. 1999; 42(5): 952-962; Sodickson DK, Manning WJ. Simultaneous acquisition of spatial harmonics (SMASH): fast imaging with radiofrequency coil arrays. Magn. Reson. Med. 1997; 38(4): 591-603) wurden neue Arrays entwickelt, die an die Parallelbildgebung angepasst sind. Arrayantennen für die Parallelbildgebung sind so angeordnet, dass ihre Empfindlichkeitsvariation in einer "undersampling"-Richtung stark ausgeprägt ist.

Unter dem Gesichtspunkt der parallelen Bildrekonstruktion im *k*-Raum (z. B. SMASH- oder GRAPPA-Verfahren) sollten die Antennenelemente so ausgerichtet sein, dass die fehlenden Rohdatenzeilen rekonstruiert werden können. Vom Standpunkt der parallelen Bildrekonstruktion im Ortsraum (z. B. SENSE-Verfahren) sollten die Teilantennen so angeordnet sein, dass Überfaltungen rechnerisch nachträglich rückgängig gemacht werden können. Mit linearen Arrays erhält man eine maximale räumliche Information in einer Richtung, während gitterartig angeordnete Arrayelemente (die auch auf gekrümmten Flächen angeordnet sein können) räumliche Informationen aus mehreren Richtungen liefern. Es wurde weiterhin gefunden, dass simultanes "undersampling" in mehren Richtungen zu einem geringeren Geometriefaktor g führt.

Die Empfindlichkeit der Teilantennen ist eine komplexe Funktion der Position und geht in den Rekonstruktionsalgorithmus ein. Somit stellt neben der Amplitude auch die Phase des in einem Arrayelement empfangenen Signals eine wichtige Informationsquelle zur Ortskodierung dar. So kann man beispielsweise Antennen in Form der Ziffer "8" in Kombination mit einfachen Kreisspulen als unabhängige Antennen im Sinn der Parallelbildgebung betrachten (siehe z. B. Hajnal JV, Larkman DJ, Herlihy DJ. An array that exploits phase for SENSE imaging. Proc. 8th Annual Meeting of the International Society for Magnetic Resonance in Medicine, Denver, CO, 2000; 171).

Insbesondere bei gitterartigen Arrays wurden bei einer Anordnung mit einem Abstand ("gap") zwischen den Antennen im Vergleich zu einer Anordnung mit Überlappung verbesserte *g-*Faktoren gefunden. In WO 2005/109010 wird die Entwicklung der Anordnung überlappender Antennen auf gekrümmten Flächen beschrieben. Neben den gitterartigen Arrays sind auch konzentrische Anordnungen von Arrayelementen (siehe z. B. Chan PH, Michael K, Anderson B. Diagonal-arranged quadrature coil arrays for 3D SENSE imaging. Proc. 12th Annual Meeting of the International Society for Magnetic Resonance in Medicine, Kyoto, 2004; 2382), Arrays mit dreieckigen Teilspulen (siehe z. B. Seeber DA, Pikelja V, Jevtic I. New RF coil topology for high performance SENSE in 3D. Proc. 11th Annual Meeting of the International Society for Magnetic Resonance in Medicine, Toronto, 2003; 465), Arrays mit mit verdrehten Spulen (siehe z. B. Mueller MF, Griswold MA, Haase A, Jakob PM. Design considerations for volumetric arrays with many elements for massively parallel MRI. Proc. 11th Annual Meeting of the International Society for Magnetic Resonance in Medicine, Toronto, 2003; 2340) oder auch Arrays auf der Basis von Volumenspulen (siehe z. B. Lin FH, Kwong KK, Huang IJ, Belliveau JW, Wald LL. Degenerate mode birdcage volume coil for sensitivity-encoded imaging. Magn. Reson. Med. 2003; 50(5): 1107-1111) in der Literatur beschrieben worden. Allgemein kann man feststellen, dass das SNR umso besser wird, je größer die Packungsdichte der verwendeten Spulen pro Flächeneinheit ist. Es wird dadurch möglich, die Bildauflösung zu erhöhen. Als entscheidender Vorteil ist weiterhin die Möglichkeit zur Nutzung von Verfahren zur Parallelbildgebung anzusehen, die wesentlich kürzere Bildaufnahmezeiten bis hin zur Echtzeitregistrierung ermöglichen.

Bei den herkömmlichen Arrayantennen spielt die Kopplung zwischen den einzelnen Teilantennen eine große Rolle, da sie zur Verschlechterung des Abstimmverhaltens, zur Verschlechterung des SNR und zu Rekonstruktionsfehlern führen kann. Neben den bereits genannten Verfahren der Überlappung der Spulen und der Vorverstärkerentkopplung nutzt man aufwendige kapazitive bzw. induktive Entkoppelnetzwerke (siehe z. B. Jevtic J. Ladder networks for capacitive decoupling in phased-array coils. Proc. 9th Annual Meeting of the International Society for Magnetic Resonance in Medicine, Glasgow, 2001; 17; Lee RF, Giaquinto RO, Hardy CJ. Coupling and decoupling theory and its application to the MRI phased array. Magn. Reson. Med. 2002; 48(1): 203-213; Jevtic J, Pikelja V, Menon A, Seeber D, Tatum N. Design guidelines for the capacitive decoupling networks. Proc. 11th Annual Meeting of the International Society for Magnetic Resonance in Medicine, Toronto, 2003; 428). Man kann aber auch nachträglich die Daten entsprechend korrigieren (siehe Song XY, Wang WD, Zhang BD, Lei M, Bao SL. Digitalization decoupling method and its application to the phased array in MRI. Prog. Nat. Sci. 2003; 13(9): 683-689) oder den Einfluss der Kopplung dadurch reduzieren, indem man die Teilantennen mit einem so genannten "hardware combiner" kombiniert, so dass ein alternativer Basissatz mit verschwindender Rauschkorrelation zwischen den Teilantennen entsteht. Aus der Literatur sind auch verschiedene Verfahren zur Abschirmung zwischen den Teilantennen bekannt. Die in WO 2005/076029 A1 beschriebene Abbildungsvorrichtung zur Nutzung der MR bewirkt eine weitgehende Abschirmung in der Spulenebene und beeinflusst das Senden und Empfangen nicht.

Die oben beschriebenen Arrays auf der Basis von Spulen haben den generellen Nachteil eines hohen Aufwands bei der Realisierung der Arrays mit relativ vielen Teilantennen. Ihr Aufbau ist insbesondere bei hoher Spulenpackungsdichte sehr aufwendig. Auch der Spulenabgleich ist oft sehr schwierig. Speziell bei höheren MR-Frequenzen, bei denen die Antennendimensionen in der Größenordnung der Wellenlänge liegen, wird es unmöglich, Antennen auf der Basis von Spulen abzustimmen. Wegen der aufwendigen Herstellung (einschließlich Abgleich) und der begrenzten Packungsdichte besteht ein Interesse an alternativen Lösungen.

Eine erhebliche Vereinfachung beim Aufbau eines Arrays bieten Antennen auf der Basis der Streifenleiter-Technik (siehe z. B. WO 03/058283; WO 02/31522; Lee RF, Hardy CJ, Sodickson DK, Bottomley PA. Lumped element planar strip array (LPSA) for parallel MRI. Magn. Reson. Med. 2004; 51(1): 172-183; US 2002/0079996; Ugurbil K,Chen W, Adriany G, Van de Moortele P, Wiesinger F, Andersen P, Strupp J, Zhang X, Snyder CJ, Chen W, Pruessmann K, Boesiger P, Vaughan JT, Ugurbil K. Transcieve stripline arrays for ultra high field parallel imaging applications. Proc. 11th Annual Meeting of the International Society for Magnetic Resonance in Medicine, Toronto, 2003; 474). Es sind insbesondere Arrays aus Streifenleiter-Antennen realisierbar, die bei geeigneter geometrischer Dimensionierung intrinsisch entkoppelt sind (Lee RF, Westgate CR, Weiss RG, Newman DC, Bottomley PA. Planar strip array (PSA) for MRI. Magn. Reson. Med. 2001; 45(4): 673-683). Streifenleiter-Antennen können auch zum lokalen Senden verwendet werden, um eine Reduktion der spezifischen Absorptionsrate (SAR) oder auch eine Homogenisierung der Anregung insbesondere auch bei höheren Feldstärken zu erreichen.

Bei planaren Streifenleiter-Arrays ist das Empfindlichkeitsprofil senkrecht zu den Streifenleitern nahezu sinusförmig (Lee RF, Westgate CR, Weiss RG, Bottomley PA. Planar Strip Array antenna for parallel spatial encoded MRI. Proc. 8th Annual Meeting of the International Society for Magnetic Resonance in Medicine; Denver, 2000; 558), was ideale Voraussetzungen für die Parallelbildgebung schafft. Auf der Basis dieser Überlegungen wurde bereits ein Array mit 64 Teilantennen auf etwa 100 cm² realisiert (McDougall MP, Wright SM, Brown DG. A 64 channel RF coil array for parallel imaging at 4.7 Tesla. Proc. 11th Annual Meeting of the International Society for Magnetic Resonance in Medicine, Toronto, 2003; 472), wobei eine Bildaufnahme in etwa 30 ms möglich ist. Driesel et al. (Proc. 13th Annual Meeting of the International Society for Magnetic Resonance in Medicine, Miami Beach, 2005; 948) nutzen die Intensitätsverteilung von Streifenleiter-Resonatoren in Leiterrichtung aus und optimierten des Feldprofil innerhalb einer Helmspule unter Einbeziehung geometrischer Überlegungen.

Streifenleiter-Antennen haben jedoch im Vergleich zu Spulen die Nachteile einer geringeren Eindringtiefe und einer schwach ausgeprägten Empfindlichkeitsvariation in Richtung der Streifenleiter, was insbesondere eine beschleunigte Bilderfassung in Richtung der Streifenleiter verhindert oder zumindest sehr erschwert.

Hinsichtlich der Eindringtiefe lassen sich zwar aus Streifenleitern aufgebaute Resonatoren in gewissem Maße optimieren, indem man beispielsweise die Dicke des Dielektrikums erhöht. Allerdings sind diesen Bemühungen Grenzen gesetzt, da man dann bei höheren Substratdicken diese Anordnungen nicht mehr im Quasi-TEM-Modus betreiben kann (Lee RF, Hardy CJ, Sodickson DK, Bottomley PA. Lumped-element planar strip array (LPSA) for parallel MRI. Magn. Reson. Med. 2004; 51: 172-183).

Aus der Literatur sind Möglichkeiten zur Beeinflussung des Feldprofils von Streifenleiter-Resonatoren bekannt. Diese dort offenbarten Steuermöglichkeiten sind jedoch "statischer" Natur, d.h. sie können nicht einfach während des Experiments modifiziert werden. Zur ersten Gruppe gehören Veränderungen der Dielektrizitätskonstante des Dielektrikums für den Aufbau der Streifenleiter und Änderungen der Geometrie der Antennenanordnung, während die zweite Gruppe hauptsächlich Maßnahmen zur sequentiellen Änderung von Terminierungen mittels schneller Schaltdioden beinhaltet. Damit gelingt es zwar über die Verschiebung der sinusförmigen Intensitätsverteilung in Richtung der Steifenleiter in Kombination mit geometrischen Maßnahmen, das Intensitätsprofil hinsichtlich geometrischer Gegebenheiten zu optimieren. Hinsichtlich der Anforderungen an das Empfindlichkeitsprofil in Richtung der Streifenleiter zur beschleunigten Bildaufnahme erreicht man mit diesen Maßnahmen keine optimalen Werte.

Eine weitere Antenne für ein MR-Gerät, welche die Merkmale des Oberbegriffs von Anspruch 1 aufweist, ist in WO 2005/111645 beschrieben.

### Aufgabe der Erfindung

Die Aufgabe der Erfindung ist es, eine verbesserte Antenne bereitzustellen, mit der die Nachteile der herkömmlichen Antennen vermieden werden. Der Erfindung liegt insbesondere die Aufgabe zugrunde, eine veränderbare Antenne für ein MR-Gerät bereitzustellen, die eine verbesserte Strukturierung der Antennenempfindlichkeit und/oder eine hohe Spulenpackungsdichte ermöglicht. Die Aufgabe der Erfindung ist es des Weiteren, eine verbesserte Antennenanordnung (Antennenarray) bereitzustellen, mit der die Nachteile der herkömmlichen Antennenanordnungen vermieden werden. Die Aufgabe der Erfindung ist es auch, ein verbessertes Verfahren zum Betrieb der Antennen oder Antennenanordnungen bereitzustellen. Das Verfahren soll insbesondere zur Steuerung der Antennen oder Antennenanordnungen und zu einer Erhöhung des räumlichen und/oder zeitlichen Auflösungsvermögens von MR-Verfahren geeignet sein.

Diese Aufgaben werden mit einer Antenne, einer Antennenanordnung, einem MR-Gerät und Verfahren mit den Merkmalen der unabhängigen Ansprüche gelöst. Vorteilhafte Ausführungsformen und Anwendungen der Erfindung ergeben sich aus den abhängigen Ansprüchen.

### Zusammenfassung der Erfindung

Gemäß einem ersten Gesichtspunkt wird die genannte Aufgabe der Erfindung durch die allgemeine technische Lehre gelöst, eine Antenne für ein MR-Gerät bereitzustellen, die für eine Anregung und/oder Erfassung einer Magnetresonanz in einem zu untersuchenden Objekt eingerichtet ist und insbesondere mindestens einen Streifenleiter-Resonator mit mindestens einem Streifenleiter und mindestens eine Leiterschleifen-Anordnung mit mindestens einer geschlossenen Leiterschleife umfasst, die mit mindestens einem Kondensator unterbrochen ist. Die mindestens eine Leiterschleifen-Anordnung ist in unmittelbarer Umgebung des Streifenleiter-Resonators angeordnet, so dass die Empfindlichkeit der Antenne am Ort des zu untersuchenden Objekts durch überlagerte Empfindlichkeitsprofile des mindestens einen Streifenleiter-Resonators und der mindestens einen Leiterschleifen-Anordnung gebildet wird. Mit der Leiterschleifen-Anordnung kann die Empfindlichkeit der Antenne beeinflusst oder gesteuert werden, so dass die Leiterschleifen-Anordnung auch als Steuervorrichtung oder Leiterschleifen-Resonator bezeichnet werden kann.

Ein wichtiger Vorteil der erfindungsgemäßen veränderbaren Antenne besteht darin, dass sie sich gegenüber herkömmlichen Antennen auf Wellenleiter-(Streifenleiter-)Basis insbesondere durch eine hohe Spulendichte und signifikante Variation des Empfindlichkeitsprofils in allen drei Raumrichtungen und Steuermöglichkeiten in weiten Grenzen auszeichnet. Vorteilhafterweise werden mit der Antenne die optimalen Voraussetzungen für die Parallelbildgebung senkrecht zu den Streifenleitern mittels der Leiterschleifen-Anordnung auf alle drei Raumrichtungen ausgedehnt. Die räumliche und/oder zeitliche Auflösung im MR-Experiment kann verbessert werden. Es ergeben sich zusätzlich Verbesserungen für HF-Shimming oder für parallele Sendetechniken. Weitere Vorteile der Antenne bestehen darin, dass sie einfach und kostengünstig herstellbar ist.

Im Unterschied zu den beschränkten Steuermöglichkeiten herkömmlicher Antennen erlaubt die erfindungsgemäße Leiterschleifen-Anordnung insbesondere in Richtung der Streifenleiter des Streifenleiter-Resonators lokal wirkungsvolle Eingriffe in das Empfindlichkeitsprofil der Antenne, die von der Auslöschung in begrenzten Bereichen bis hin zu einer signifikanten Erhöhung reichen. Damit weicht das Empfindlichkeitsprofil der Antenne in dieser Richtung merklich vom Zustand ohne Leiterschleifen-Anordnung ab, und eine Anregung gemäß verschiedenen Empfindlichkeitsprofilen in Kombination mit mehreren HF-Sendern bzw. geeignet aufbereiteter Sendesignalen kann parallel im Untersuchungsobjekt erfolgen. Damit werden zusätzliche Freiheitsgrade zur selektiven räumlichen Anregung von 3-dimensionalen Objekten erreicht. Somit wird mit der erfindungsgemäß vorgeschlagenen Antenne insbesondere hinsichtlich der 3D-Beschleunigung eine optimale Antennenanordnung erreicht.

Gemäß einem zweiten Gesichtspunkt wird die genannte Aufgabe der Erfindung durch die allgemeine technische Lehre gelöst, eine Antennenanordnung bereitzustellen, die eine Vielzahl von erfindungsgemäßen Antennen umfasst. Die Antennenanordnung ist eine zu einem Feld (Array) zusammengefasste Gruppe von Antennen. Sie wird zur Erzeugung und zum Empfang von magnetischen Wechselfeldern im Nahfeld für den Einsatz zur MR-Bildgebung und MR-Spektroskopie benutzt. Sie eignet sich besonders beim Senden zur lokalen Anregung von begrenzten Gebieten oder zur Homogenisierung der Anregung insbesondere bei höheren Frequenzen. Beim Empfang von MR-Signalen zeichnet sie sich durch eine Erhöhung des SNR in spulennahen Bereichen und/oder eine beschleunigten Bildaufnahme aus.

Ein weiterer wichtiger Vorteil der erfindungsgemäßen Antennenanordnung besteht in der einfachen Realisierung. Mit einer Aneinanderreihung von mehreren erfindungsgemäßen Antennen kann ein dreidimensionales Array geschaffen werden, das ggf. geometrisch an eine vorbestimmte Form des zu untersuchenden Objekts, z. B. an eine zu untersuchende Körperregion (z. B. den Kopf oder ein Gelenk) angepasst werden kann und eine hohe Flexibilität bezüglich des Einsatzes ermöglicht.

Gemäß einem dritten Gesichtspunkt wird die genannte Aufgabe der Erfindung durch die allgemeine technische Lehre gelöst, ein MR-Gerät bereitzustellen, das mindestens eine erfindungsgemäße Antenne und/oder mindestens eine erfindungsgemäße Antennenanordnung umfasst.

Gemäß einem vierten Gesichtspunkt wird die genannte Aufgabe der Erfindung durch die allgemeine technische Lehre gelöst, ein Verfahren zur MR-Bildgebung oder MR-Spektroskopie an einem zu untersuchenden Objekt bereitzustellen, bei dem eine Anregung und/oder eine Erfassung einer Magnetresonanz in dem Objekt mit mindestens einer erfindungsgemäßen Antenne und/oder mindestens einer erfindungsgemäßen Antennenanordnung vorgesehen ist. Das Verfahren zeichnet sich insbesondere durch eine verbesserte Steuerung der mindestens einen Antenne aus. Das Verfahren ermöglicht insbesondere eine Beeinflussung der Sende- und Empfangsempfindlichkeiten der Antenne(n) und somit deren Optimierung während der Untersuchung.

Der Streifenleiter-Resonator der erfindungsgemäßen Antenne wird mittels verlustarmer Wellenleiter aufgebaut, die auf einem Dielektrikum oder selbsttragend angeordnet und bezüglich einer oder mehrerer Larmor-Frequenzen resonant abgestimmt sind. Die Funktion des Streifenleiter-Resonators baut auf dem aus der Leitungstheorie bekannten Sachverhalt auf, dass sich auf Wellenleitern stehende Wellen ausbilden, wenn man einen Wellenleiter nicht mit einem ohmschen Widerstand abschließt, dessen Größe dem Wellenwiderstand entspricht. Eigenschaften von auf Wellenleitern basierenden Resonatoren sind an sich aus dem Stand der Technik bekannt. Einzelheiten können z. B. aus EP 1 624 314 A1 entnommen werden, auf die hiermit insbesondere hinsichtlich der Geometrie, Dimensionierung, Optimierung und Ansteuerung der auf Wellenleitern basierenden Streifenleiter-Resonatoren verwiesen wird.

Zur Veränderung der Antennenempfindlichkeit, insbesondere zur Variation des Feldprofils wird erfindungsgemäß mindestens ein weiterer, schichtförmiger Leiter etwa senkrecht zu dem bereits vorhandenen Streifenleiter innerhalb und/oder außerhalb des Dielektrikums des Streifenleiter-Resonators angeordnet. Der schichtförmige Leiter bildet eine geschlossene Schleife, die an mindestens einer Stelle mit mindestens einem Kondensator unterbrochen ist. Mit dem mindestens einen Kondensator, ggf. durch Verwendung weiterer Reaktanzen, wird die Schleife ebenfalls auf eine oder mehrere Larmor-Frequenzen abgestimmt. Diese zusätzlich angebrachte leitfähige Struktur, die resonant abgestimmt ist, ggf. auch verstimmt, geöffnet oder kurzgeschlossen werden kann, wird hier als "Leiterschleifen-Anordnung" bezeichnet. Mit der Leiterschleifen-Anordnung wird die Antennenempfindlichkeit beeinflusst.

Die Erfinder haben festgestellt, dass die zusätzlich innerhalb und/oder außerhalb vom Streifenleiter-Resonator angebrachte Leiterschleifen-Anordnung bei geeigneter Dimensionierung weitgehend vom Streifenleiter-Resonator entkoppelt ist oder ggf. zusätzlich durch kapazitive bzw. induktive Entkoppelnetzwerke entkoppelt werden kann. So ist es möglich, sowohl den Streifenleiter-Resonator als auch die Leiterschleifen-Anordnung unabhängig voneinander anzusteuern. Die vom Streifenleiter-Resonator und von der Leiterschleifen-Anordnung erzeugten Felder überlagern sich im zu untersuchenden Objekt je nach Phasenlage und Amplitude der angeschlossenen Sender konstruktiv bzw. destruktiv. Somit kann man das resultierende Feldprofil in weiten Grenzen verändern und den Erfordernissen der Untersuchung anpassen (z. B. so genanntes "HF-Shimming" oder parallele Sendetechniken). Gleiches gilt für den Empfangsfall: auch hier hat man die Möglichkeit, die Signale einzeln zu nutzen oder mittels Phasenschiebern in unterschiedlicher Weise zu kombinieren und für Verfahren zur Parallelbildgebung zu nutzen.

Die Leiterschleifen-Anordnung weist mindestens eine Leiterschleife auf, deren Leiter durch den mindestens einen Kondensator unterbrochen ist. Der Leiter ist schichtförmig gebildet. Schichtförmige Leiter können Vorteile in Bezug auf die Formung des Feldprofils, die Verringerung der kapazitiven Kopplung und die Herstellung der Antenne haben.

Da gemäß der Erfindung das von der Leiterschleifen-Anordnung erzeugte Feld relativ zu dem vom Streifenleiter-Resonator erzeugten Feld orthogonal ausgerichtet ist, ergeben sich Vorteile hinsichtlich der Entkopplung zwischen Leiterschleifen-Anordnung und Streifenleiterresonator. Es kann weiterhin vorteilhaft sein, orthogonal zueinander stehende Streifenleiter-Resonatoren in Kombination mit ihren Leiterschleifen-Anordnungen in Quadratur zu betreiben. Dies führt zu einer Verminderung der erforderlichen Sendeleistung und zu einem verbesserten SNR beim Empfang. Diese Vorteile basieren insbesondere auf der Erkenntnis, dass es bei in Quadratur betriebenen Spulen zu einer Halbierung der erforderlichen Sendeleistung kommt, und dass sich im Empfangsfall das SNR um den Faktor 1,4 erhöht.

Ein weiterer Vorteil der Erfindung besteht in der Variabilität bei der Auswahl der Gestalt der Leiterschleife der Leiterschleifen-Anordnung. Wenn die Leiterschleife gemäß einer Variante der Erfindung einen einzigen Ring oder ein einziges Vieleck bildet, wird der Aufbau der Antenne vorteilhafterweise vereinfacht. Gemäß einer abgewandelten Variante kann erfindungsgemäß die mindestens eine Leiterschleife mit mehreren Ringen oder Vielecken vorgesehen sein, die z. B. in Richtung des Streifenleiters des Streifenleiter-Resonators angeordnet sind und von einem Abstimmnetzwerk unterbrochen sein können. Die Leiterschleifen umfassen Leiterabschnitte, die eine geometrische Schleifenform bilden.

Die Schleifenform kann insbesondere eine so genannte Leiterform aufweisen, bei der seitliche Leiterabschnitte gerade oder gekrümmte Holme und mittlere Leiterabschnitte gerade oder gekrümmte Sprossen bilden. Es kann auch vorteilhaft sein, Verbindungsstücke zwischen Leiterabschnitten kapazitiv oder mit einem Abstimmnetzwerk zu unterbrechen. Die Leiterschleifen-Anordnung kann alternativ aus mehreren Leiterformen mit mindestens drei Sprossen bestehen, wobei die angrenzenden Holme mit einem vorbestimmten Abstand, überlappend oder durch einen gemeinsamen Holm ausgeführt sein können.

Ausdrücklich in die Erfindung einbezogen sind weitere von der klassischen Leiterform abweichende Gestaltungsmöglichkeiten mit von der Rechteckform oder Kreisform abweichenden Formen. Die Schleifenform kann insbesondere eine so genannte Kettenform aufweisen, bei der Leiterabschnitte rhombusförmig angeordnet sind.

Es können z. B. mehrere einfache Schleifen oder Doppelschleifen (so genannte "Ziffer-8-Spulen") oder deren gemischte Anordnungen in Längs- oder Querrichtung des Streifenleiter-Resonators vorgesehen sein. Eine Doppelschleife oder "Ziffer-8-Spule" ist allgemein eine Leiterschleife, deren Leiter insbesondere in Form von Ringen oder Vielecken eine topologische Form mit zwei Löchern bilden. Eine Linie, die dem Verlauf der "Ziffer-8-Spule" folgt, lässt sich auf die Form der Ziffer "8" abbilden. Die "Ziffer-8-Spule" kann z. B. eine Kastenform mit zwei viereckigen Schleifen aufweisen.

Somit kann eine Leiterschleifen-Anordnung mit mehreren Leiterschleifen bereitgestellt werden, die eigenständige, separat ansteuerbare resonante Strukturen bilden, so dass mit dem Begriff Leiterschleifen-Anordnung auch ein Array von Einzelresonatoren bezeichnet werden kann. Man kann erfindungsgemäß dem Streifenleiter-Resonator insbesondere mehrere separate Leiterschleifen-Anordnungen innerhalb und/oder außerhalb des Dielektrikums des Streifenleiter-Resonators z. B. in Form von weiteren Leiterschleifen oder als Leiterform-Struktur oder alternierend (z. B. einfache Schleife und Leiterform-Struktur), mit Abstand oder teilweise überlappend hinzufügen und so ein Array von Einzelresonatoren z. B. in Längsrichtung des Streifenleiter-Resonators schaffen. Wenn mindestens eine der Leiterschleifen eine Leiterform und mindestens eine weitere Leiterschleife eine einfache Schleife (insbesondere Ring oder Vieleck) umfasst, können sich im konkreten Anwendungsfall Vorteile für die Variabilität der Einstellung der Antennenempfindlichkeit ergeben.

Das Array von Einzelresonatoren muss sich nicht notwendigerweise längs einer Geraden im Raum erstrecken, sondern kann sich auch längs einer gekrümmten Linie oder eines Polygonzuges erstrecken. Derartige veränderbare Antennen für ein MR-Gerät in Form eines linearen Arrays kann man auch senkrecht zu der Richtung des oben beschriebenen eindimensionalen Arrays mehrfach nebeneinander anordnen und erhält auf diese Weise ein zweidimensionales Array. Da auch die Erweiterung in dieser Richtung nicht notwendigerweise längs einer geraden Linie verlaufen muss, kann man so auch ein dreidimensionales Array mit sehr hoher Packungsdichte schaffen. Die geometrische Form eines derartigen dreidimensionalen Arrays kann auch an die Form der zu untersuchenden Organe (Gebiete) angepasst werden, was zu optimalen Voraussetzungen, sowohl für das Einstrahlen der HF als auch im Empfangsfall führt.

Gemäß einer weiteren Modifizierung der Erfindung kann die Antenne mehrere Leiterschleifen-Anordnungen, ggf. mit den genannten Variationen, aufweisen, die übereinander angeordnet sind. Die Leiterschleifen-Anordnungen bilden innerhalb oder an den Streifenleiter-Resonator angrenzend einen Stapel. Vorteilhafterweise ergeben sich in diesem Fall weitere Freiheitsgrade zur Einstellung der Antennenempfindlichkeit.

Gemäß einer bevorzugten Ausführungsform der Erfindung weist die Antenne eine Abstimmeinrichtung auf, mit der die Antenne auf mindestens eine Larmor-Frequenz abstimmbar ist. Vorteilhafterweise kann damit die Antenne einfach an verschiedene MR-Untersuchungsaufgaben, z. B. auf die Messung eines speziellen oder verschiedener Atomkerne angepasst werden. Es besteht eine hohe Variabilität bei der Gestaltung der Abstimmeinrichtung, die zum Beispiel zur Abstimmung verschiedener Teile (Einzelresonatoren) der Antenne auf unterschiedliche Larmor-Frequenzen oder zur Abstimmung vorbestimmter Teile der Antenne auf mehrere Larmor-Frequenzen eingerichtet sein kann.

Die Abstimmeinrichtung kann ein Netzwerk von Reaktanzen (Kapazitäten und/oder Induktivitäten) umfassen, das mit der Antenne verbunden ist. Besonders bevorzugt ist der mindestens eine Kondensator der Leiterschleife der Leiterschleifen-Anordnung als Teil der Abstimmeinrichtung.

Die Flexibilität der Anpassung an verschiedene Messbedingungen kann vorteilhafterweise erhöht werden, wenn die Antenne gemäß einer weiteren vorteilhaften Ausführungsform der Erfindung eine Schalteinrichtung aufweist, über welche die Antenne mit der Abstimmeinrichtung verbunden ist, und mit der die Empfindlichkeit der Antenne veränderlich ist. So kann es in Abhängigkeit von der konkreten Anwendung bzw. der konkreten Lage des interessierenden Gebietes im Objekt erforderlich sein, Streifenleiter-Resonatoren und/oder Leiterschleifen-Anordnungen teilweise oder ganz zu öffnen, zu verstimmen oder ggf. kurzzuschließen. Hierzu werden besonders bevorzugt PIN-Dioden ("positive intrinsic negative diodes") ggf. in Kombination mit Varactor-Dioden und/oder weiteren Reaktanzen verwendet. Vorteilhafterweise wird damit auch eine Fernbedienung der Schalteinrichtung ermöglicht.

Soll ein Streifenleiter-Resonator und/oder eine Leiterschleifen-Anordnung geöffnet werden, so schaltet man mittels einer Steuergleichspannung mit einer PIN-Diode eine geeignet dimensionierte Induktivität parallel zu einem spannungsfesten Kondensator (beispielsweise dem Abstimmkondensator) im Resonanzkreis. Die schaltbare Induktivität ist dabei so bemessen, dass sie mit dem ausgewählten Kondensator einen Parallelresonanzkreis bei der gewünschten Frequenz bildet.

Soll ein Streifenleiter-Resonator und/oder eine Leiterschleifen-Anordnung verstimmt werden, so schaltet man mittels einer Steuergleichspannung mit einer PIN-Diode eine geeignet dimensionierte Kapazität (oder auch eine Varactordiode) parallel oder ggf. in Serie zum Abstimmkondensator im Resonanzkreis. Die schaltbare Kapazität ist dabei so bemessen, dass sie den Resonanzkreis auf die gewünschte neue Frequenz abstimmt. Das gezielte Verstimmen kann als Zwischenstufe zur Optimierung von Empfindlichkeitsprofilen bei bestimmten Anwendungen nützlich sein (HF-Shimming, lokale Anregung, lokaler Empfang).

Soll hingegen ein Streifenleiter-Resonator und/oder eine Leiterschleifen-Anordnung kurzgeschlossen werden, so ist dies am einfachsten zu erreichen, indem mittels einer Steuergleichspannung leitfähig geschaltete PIN-Dioden über den Kondensatoren des Streifenleiter-Resonators und/oder der Leiterschleifen-Anordnung angeordnet und kurzgeschlossen werden.

Vorteilhafterweise kann die erfindungsgemäße Antenne ausschließlich als Sendeantenne ausgebildet sein. In diesem Fall ist der mindestens eine Kondensator in der Leiterschleife und der übrige Aufbau für die beim Senden auftretenden Spannungen im kV-Bereich ausgelegt. Die Kapazität beträgt z. B. mindestens 0,1 pF, vorzugsweise mindestens 0,5 pF. Die Leiterschleifen-Anordnung kann ebenso, wie der Streifenleiter-Resonator über den mindestens einen Abstimm-Kondensator bzw. ein Abstimmnetzwerk und eine Anpassanordnung im Sendefall mit dem Sender verbunden werden. Alternativ kann die erfindungsgemäße Antenne ausschließlich als Empfangsantenne ausgebildet sein. In diesem Fall sind der mindestens eine Kondensator in der Leiterschleife für die beim Empfang auftretenden Spannungen im mV-Bereich ausgelegt, wobei die Kapazität z. B. 0,1 pF, vorzugsweise mindestens 0,5 pF beträgt, und die Antenne an einen Vorverstärker angeschlossen ist. Die Leiterschleifen-Anordnung kann ebenso wie der Streifenleiter-Resonator über den mindestens einen Kondensator (Abstimm- oder Tune-Kondensator) bzw. ein Abstimm-Netzwerk und eine Anordnung zum "matching" im Empfangsfall mit einem Vorverstärker verbunden werden.

Bevorzugt ist die erfindungsgemäße Antenne jedoch als Sende-Empfangs-Antenne ausgebildet. Für diesen Fall sind jeder Streifenleiter-Resonator und jede Leiterschleifen-Anordnung über einen Umschalter entweder mit einem Empfänger oder einem Sender des MR-Gerätes koppelbar. Der Umschalter wird wegen seiner Funktion auch als T/R-Umschalter (Transmitter/Receiver) bezeichnet.

Das erfindungsgemäße Verfahren zeichnet sich somit dadurch aus, dass die Antenne als Sende-Antenne, Empfangs-Antenne oder als Sende-Empfangs-Antenne oder im alternierenden Betrieb oder für eine sendeseitige oder empfangsseitige Parallelbildgebungs-Technik oder eine Kombination aus beiden Verfahren verwendet wird.

Ein weiterer wichtiger Vorteil der Erfindung besteht in der hohen Flexibilität bei der Anpassung an verschiedene Untersuchungsaufgaben. So können die Antennen der erfindungsgemäßen Antennenanordnung auf einer gekrümmten Fläche angeordnet werden. In Verbindung mit der Einstellbarkeit der Antennenempfindlichkeit können somit im MR-Gerät alle gewünschten Magnetfeld-Richtungen und/oder Amplituden im zu untersuchenden Objekt erzeugt (senden) oder detektiert (empfangen) werden. Die Antennen können insbesondere auf einer derart gekrümmten Fläche angeordnet sein, dass ein Untersuchungsraum gebildet wird, der zur Aufnahme des zu untersuchenden Objekts eingerichtet ist. Die gekrümmte Fläche schließt einen Hohlraum ein, in dem das Objekt im MR-Gerät angeordnet werden kann.

Des Weiteren kann die mindestens eine Antenne im MR-Gerät so angeordnet sein, dass die Antennenempfindlichkeit in radialer Richtung relativ zum statischen Magnetfeld des MR-Geräts maximal ist, wobei sich Vorteile für eine hohe Empfindlichkeit der MR-Untersuchung ergeben können. Alternativ kann die Antenne gegenüber der Richtung des statischen Magnetfeldes verdreht (z. B. längs einer Helix) angeordnet sein.

Durch die Verkippung der Antenne relativ zum statischen Magnetfeld kann man einen Kompromiss zwischen einer verbesserten Beschleunigung in z-Richtung und einer hohen Empfindlichkeit in x-y-Richtung einstellen.

### Kurzbeschreibung der zeichnungen

Weitere Einzelheiten und Vorteile der Erfindung werden im Folgenden unter Bezugnahme auf die beigefügten Zeichnungen beschrieben. Es zeigen:
- Figur 1:: eine erste Ausführungsform einer erfindungsgemäßen Antenne;
- Figur 2:: eine erste Ausführungsform einer erfindungsgemäßen Antennenanordnung;
- Figur 3:: eine schematische Illustration einer bevorzugten Ausführungsform eines erfindungsgemäßen MR-Geräts mit Antennenanordnung;
- Figuren: 4 und 5: weitere Ausführungsformen der erfindungsge- mäßen Antenne;
- Figur 6:: eine beispielhafte Illustration der Antennenempfind- lichkeit einer erfindungsgemäßen Antenne;
- Figuren 7 bis 9 und 11 bis 13:: weitere Ausführungsformen der erfindungsge- mäßen Antenne;
- Figuren 10 und 14:: weitere Antennen (Keine Ausführungsformen der Erfindung)
- Figuren 15 und 16:: schematische Illustrationen von Schaltun- gen zur Steuerung oder Abstimmung der erfindungsge- mäßen Antenne; und
- Figur 17:: eine weitere Ausführungsform der erfindungsgemäßen Antennenanordnung.

### Bevorzugte Ausführungsformen der Erfindung

Ausführungsformen der Erfindung werden im Folgenden unter beispielhaftem Bezug auf Antennen beschrieben, deren Leiterschleifen-Anordnung mindestens eine rechteckige Leiterschleife mit einem Leiter oder Leiterabschnitten in Form eines schichtförmigen Bandes umfasst. Die Umsetzung der Erfindung ist nicht auf die dargestellten Beispiele beschränkt, sondern in entsprechender Weise mit Leiterschleifen-Anordnungen realisierbar, die anders geformte Leiterschleifen aufweisen. Des Weiteren ist anzumerken, dass die unten angegebenen Kapazitätswerte Beispielwerte darstellen, die bei der praktischen Anwendung insbesondere in Abhängigkeit von der Beladung der Spulen mit Gewebe den Gegebenheiten angepasst werden können. Der Fachmann kann die Beispielwerte als Startwerte verwenden, um nach an sich bekannten Simulationsrechnungen und einer Feinabstimmung zu Werten für eine konkrete Anwendung zu gelangen. Für Simulationsrechnungen kann z. B. die Software HFSS (frequency structure simulator, Hersteller: Ansoft, Version 11) in Kombination mit der Software "Designer" (Hersteller: Ansoft, Version 3.5) verwendet werden. Schließlich kann die hier unter Bezug auf die MR-Bildgebung beschriebene Erfindung analog auch in der EPR-Technik angewendet werden.

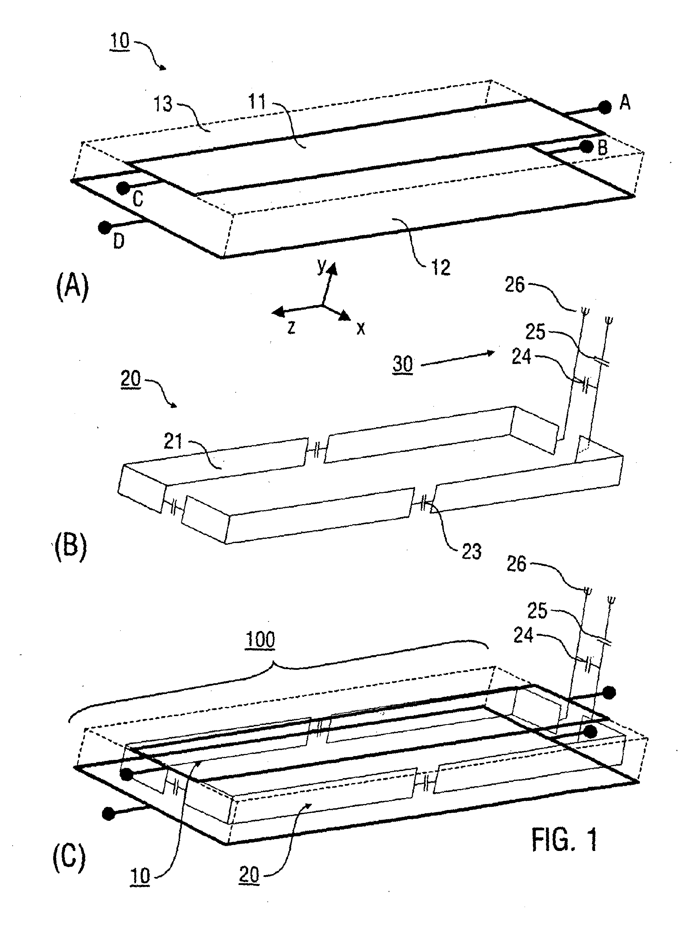

Figur 1 illustriert ein erstes Beispiel der erfindungsgemäßen veränderbaren Antenne 100 (Figur 1C), deren Komponenten Streifenleiter-Resonator 10 und Leiterschleifen-Anordnung 20 aus Übersichtlichkeitsgründen in den Figuren 1A und 1B einzeln gezeigt sind.

Der Streifenleiter-Resonator 10 der Antenne 100 weist einen ersten Leiterstreifen 11 und einen zweiten Leiterstreifen 12 (Leiterfolie 12) auf, die durch ein Dielektrikum 13 getrennt sind (Figur 1A). Der Streifenleiter-Resonator 10 ist in an sich bekannter Weise aufgebaut. Richtlinien zur Gestaltung des Streifenleiter-Resonators 10 finden sich z. B. in den Publikationen Bahl IJ, Trivedl DK. A designer's guide to micostrip line. Microwaves, May 1977; 174-179; Schnieder F, Heinrich W. Model of thin-film microstrip line for circuit design. IEEE Trans. Microwave Theory Techniques 2001; 49: 104-110; Itoh T. Overview of quasi-planar transmission lines. IEEE Trans. Microwave Theory Techniques 1989; 37: 275-280.

An einem ersten, nicht kurzgeschlossenen Ende vom Streifenleiter-Resonator 10 sind die Anschlüsse A/B vorgesehen, an denen über eine Abstimmeinrichtung 30 die Ankopplung und Abstimmung des Streifenleiter-Resonators 10 erfolgt.

Die elektrische Ankoppelung des Streifenleiter-Resonators 10 kann kapazitiv (am Spannungsmaximum) oder induktiv am Strommaximum erfolgen. Mit einem Parallel-Kondensator (Tune-Kondensator) kann der Streifenleiter-Resonator auf die gewünschte Lamor-Frequenz abgestimmt werden. Die Ankopplung an den Sender/Empfänger erfolgt über einen oder mehrere Serien-Kondensatoren (Match-Kondensatoren). Die Resonanzfrequenz wird entsprechend der Larmor-Frequenz der untersuchten Atomkerne gewählt, die bspw. für Wasserstoffkerne (Protonen) 127,7 MHz und für Phosphorkerne 51,8 MHz in einem statischen Magnetfeld von 3,0 T beträgt.

Es sei hier angemerkt, dass der Streifenleiter-Resonator 10 auf die Larmor-Frequenz für Protonen bei anderen Feldstärken oder auf die Larmor-Frequenz für andere Kerne mit einem von Null verschiedenen Kernspin oder für mehrere Larmor-Frequenzen abgestimmt werden kann und dass der/die Abstimmkondensator(en) nicht notwendigerweise am offenen Ende der Streifenleitung angebracht werden muss/müssen, sondern auch an anderen Stellen (z. B. als Brücke im Dielektrikum) angebracht sein kann/können. Es soll weiterhin angemerkt werden, dass zur Erfüllung der Resonanzbedingung auch zusätzlich noch entsprechend dimensionierte diskrete Reaktanzen an verschiedenen Stellen des Streifenleiters angebracht werden können.

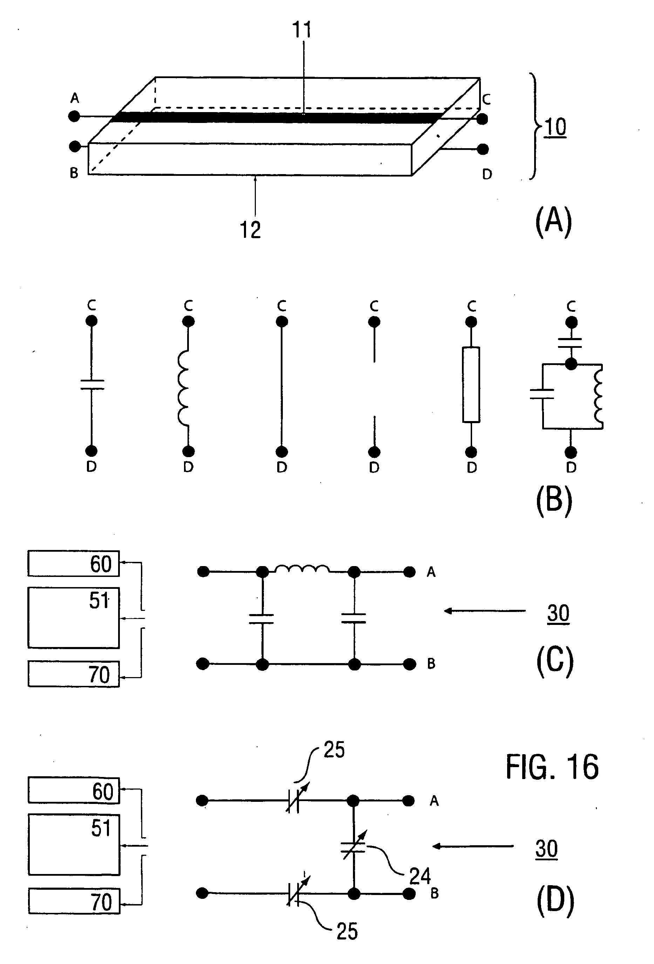

An einem zweiten Ende vom Streifenleiter-Resonator 10 sind die Anschlüsse C/D vorgesehen, an denen die Streifenleiter terminiert sind. Im vorliegenden Fall ist eine offene Terminierung gezeigt, wobei auch andere Terminierungen vorteilhaft sein können (Kurzschluss, kapazitiv, induktiv, ohmscher Widerstand, siehe auch Figur 16). Insbesondere in Abhängigkeit von der Terminierung wird ein vorbestimmter Feldverlauf des Streifenleiter-Resonators 10 gebildet.

Die Breite des Streifenleiters 11 beträgt z. B. 1,5 cm. Die Maße des Dielektrikums 13 (im Anwendungsbeipiel Polypropylen, PP) betragen z. B. 7 cm (Breite), 1,5 cm (Dicke) und 30 cm (Länge). Die vorgegebenen Maße stellen lediglich ein Beispiel dar und können in Abhängigkeit von den Anwendungsbedingungen in weiten Grenzen variiert werden. Die Unterseite des Dielektrikums ist mit etwa 5 cm breiter Leiterfolie 12 beschichtet, die z. B. selbstklebende Kupferfolie umfasst. Es wurde z. B. Kupferfolie mit einer Dicke etwa gleich der doppelten Skindicke verwendet (12 µm dick), um die Ausbildung von Wirbelströmen gering zu halten.

Es sei angemerkt, dass sich die erfindungsgemäße Antenne auch mit davon abweichend dimensionierten Streifenleitern sowie mit einer unterschiedlichen Anzahl von Streifenleitern realisieren lässt. Weiterhin sei angemerkt, dass als Dielektrikum für die Streifenleiter auch Luft (bzw. Vakuum) vorgesehen sein kann. Für diesen Fall werden die leitenden Schichten selbsttragend ausgeführt werden oder auf der Gegenseite jeweils mittels eines Dielektrikums stabilisiert. Neben PP als Dielektrikum kommen u. a. auch andere Dielekrika, wie Polytretrafluorethylen (PTFE) oder PTFE mit Einlagerungen von Keramikpulver und andere verlustarme Substrate in Frage. Anstelle des Aufklebens der Leiterfolie sind andere Verfahren zur Aufbringung von Metallisierungen anwendbar.

Der Streifenleiter 11 kann des Weiteren wie folgt modifiziert werden. Der Streifenleiter kann an den beiden Enden terminiert sein, während ein Speisepunkt entlang der Länge des Leiterstreifens 11, z. B. an dessen halber Länge vorgesehen ist. Hier kann die Einstellung der Terminierung in Kombination mit geometrischen Überlegungen zur Feldoptimierung genutzt werden. Wenn z. B. an beiden Enden des Streifenleiter-Resonators 10 als Terminierung ein Kurzschluss angenommen wird, erzwingt dies ein Strommaximum und damit auch ein Feldmaximum an den beiden Enden des Streifenleiters 11. Bei offener Terminierung läge das Strommaximum im mittleren Bereich des Streifenleiters 11. Des Weiteren kann der Streifenleiter 11 aus mehreren separaten, nebeneinander angeordneten Teilstreifen bestehen, wie dies aus dem Stand der Technik bekannt ist.

Erfindungsgemäß enthält die veränderbaren Antenne 100 zusätzlich zum Streifenleiter-Resonator 10 (Figur 1A) die in Figur 1B gezeigte Leiterschleifen-Anordnung 20. Die Leiterschleifen-Anordnung 20 weist eine Leiterschleife 21 auf, in die mehrere Kondensatoren 23 geschaltet sein können, wobei jedoch mindestens ein Kondensator 23 vorhanden ist. Die Kondensatoren 23 sind zur Homogenisierung des von der Leiterschleifen-Anordnung 20 erzeugten Feldes und zur Verringerung der Wechselwirkung der Leiterschleifen-Anordnung 20 zur Erde bzw. zu anderen Anordnungen (über das elektrische Feld) vorgesehen. Die Kondensatoren 23 sind im Wesentlichen äquidistant positioniert, so dass die Leiterschleife in über die Kondensatoren verbundene Leiterstücke gleicher Länge aufgeteilt wird.

Die Leiterschleife 21 der Leiterschleifen-Anordnung 20 besteht im einfachsten Fall z. B. aus einer Leiterschleife, die durch eine Cu-Schicht gebildet wird, mit einer Länge von 28 cm, einer Breite von 7 cm, einer Streifenbreite der Leiter von 5 mm und einer Dicke der Cu-Schicht von 12 µm. Die Breite der Leiterschleife 21 entspricht in diesem Ausführungsbeispiel etwa der Breite des Dielektrikums des Streifenleiter-Resonators 10. Die Kondensatoren 23 umfassen Festkörperkondensatoren, wie z. B. Keramik-Chipkondensatoren mit nichtmagnetischen Kontaktflächen, die mit den angrenzenden Leiterstücken der Leiterschleife 21 elektrisch verbunden sind.

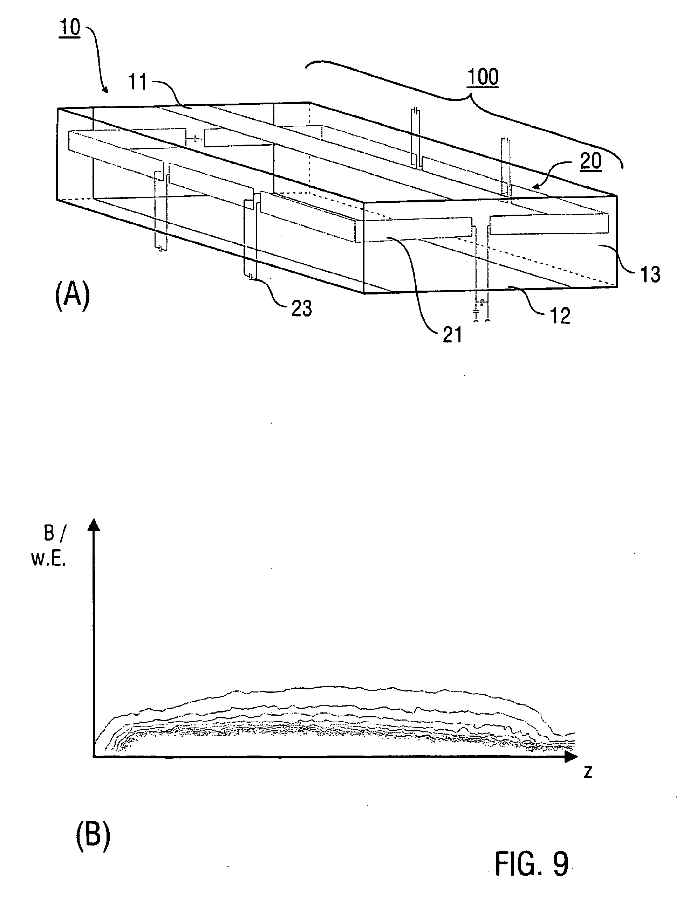

Zur Herstellung der kompletten Antenne 100 wird die Leiterschleifen-Anordnung 20 teilweise in das Dielektrikum 13 des Streifenleiter-Resonators 10 eingebettet. Zweckmäßigerweise wird an den betreffenden Stellen eine Nut im Dielektrikum angebracht, wo der Leiter geführt wird. Dies kann im einfachsten Fall mechanisch mit einem Fräser geschehen. Weitere Beispiele von Verfahren zur Herstellung der Antenne sind unten, insbesondere unter Bezug auf die Figuren 9 bis 11 angegeben.

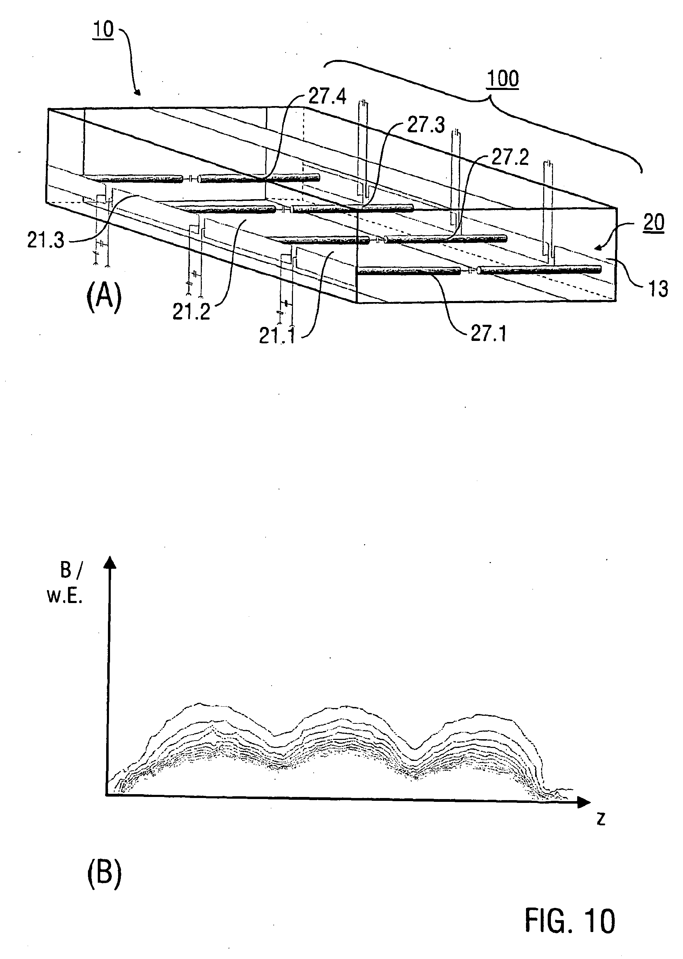

Die komplette veränderbare Antenne 100 ist in Figur 1C dargestellt. Sie besitzt in diesem Fall zwei Anschlüsse 26, einen für den Streifenleiter-Resonator und einen weiteren für die Leiterschleifen-Anordnung, an denen hochfrequente elektrische Leistung unterschiedlicher Phasenlage und Amplitude eingespeist werden kann. Die Anschlüsse 26 sind im einfachsten Fall über eine Anpassungsanordnung, ggf. über Leistungssplitter und Phasenschieber sowohl mit dem Anschluss A/B des Streifenleiter-Resonators 10 als auch mit der Leiterschleife 21 der Leiterschleifen-Anordnung 20 verbunden. Im Fall des Empfangs von Signalen kann hier direkt (bei einer reinen Empfangsantenne) oder über einen T/R-Umschalter (bei einer Sende-Empfangs-Antenne, siehe Figur 10) das empfangene Signal abgegriffen werden.

Als Abstimmkondensator (C_{T}) für den Streifenleiter-Resonator werden zweckmäßigerweise ein oder mehrere Parallelkondensatoren vom Streifenleiter 11 zum Streifenleiter 12 verwendet. Diese Kondensatoren können am Ende am Anschluss A/B und/oder im Dielektrikum 13 angeordnet sein. Im Fall der Leiterschleifen-Anordnung nutzt man einen oder mehrere Kondensatoren in der Leiterschleife, die man in ihrem Wert gemäß der Thomsonschen Gleichung so wählt, dass sie zusammen mit den dazugehörigen Teilinduktivitäten der Leiterschleife bei der gewünschten Lamor-Frequenz eine Resonanz bilden. Um den Streifenleiter-Resonator und die Leiterschleifen-Anordnung anzusteuern, nutzt man je einen von außen zugänglichen Abstimmkondensator und verbindet diesen mit einem (oder vorzugsweise mehreren) Serien-Kondensator(en) 25 (Anpassungs-Kondensator, C_{M}), die zur Einkopplung der hochfrequenten Spannung und zur Anpassung der Resonatoren verwendet werden.

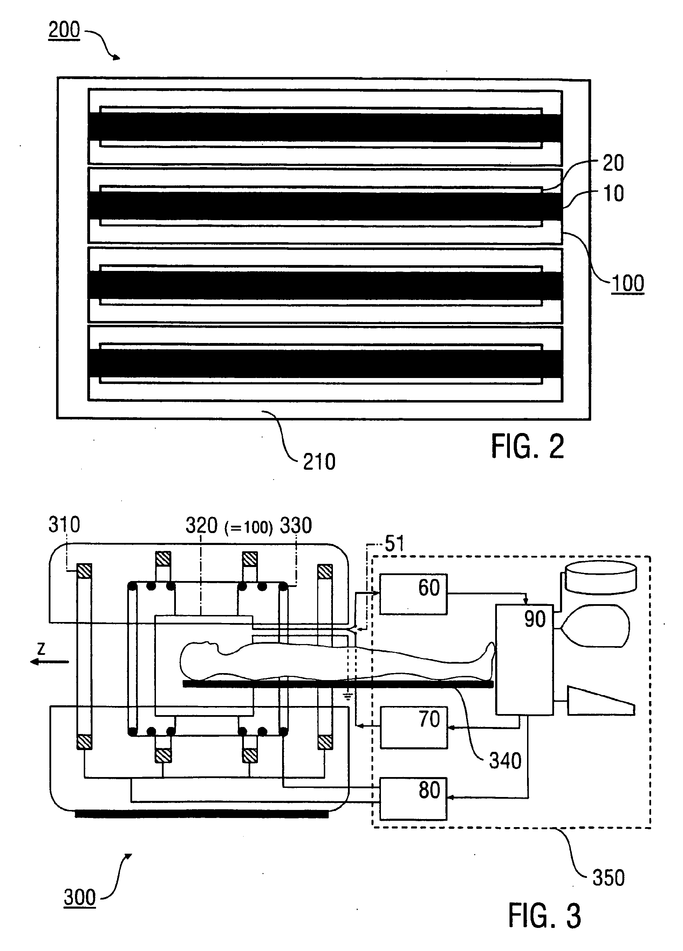

Der einzelne Streifenleiter-Resonator 10 erzeugt ein Magnetfeld, wie es von herkömmlichen Streifenleiter-Resonatoren bekannt ist (siehe z. B. Figur 16A, oder Figur 3 in EP 1 624 314 A1). Bei paralleler Anordnung von mehreren Streifenleiter-Resonatoren (siehe z. B. Figur 2) kann es bei einer eventuell vorliegenden Kopplung zwischen den Resonatoren zu geänderten Empfindlichkeiten kommen, da die Streifenleiter-Resonatoren in unterschiedlichen Schwingungsmoden schwingen können (siehe insbesondere Figur 3 in EP 1 624 314 A1). In Abhängigkeit von der konkreten Antennenanordnung ist bei der Steuerung der Antenne 100 von einem derart veränderten Spulenempfindlichkeits-Bild (Feldbild) auszugehen.

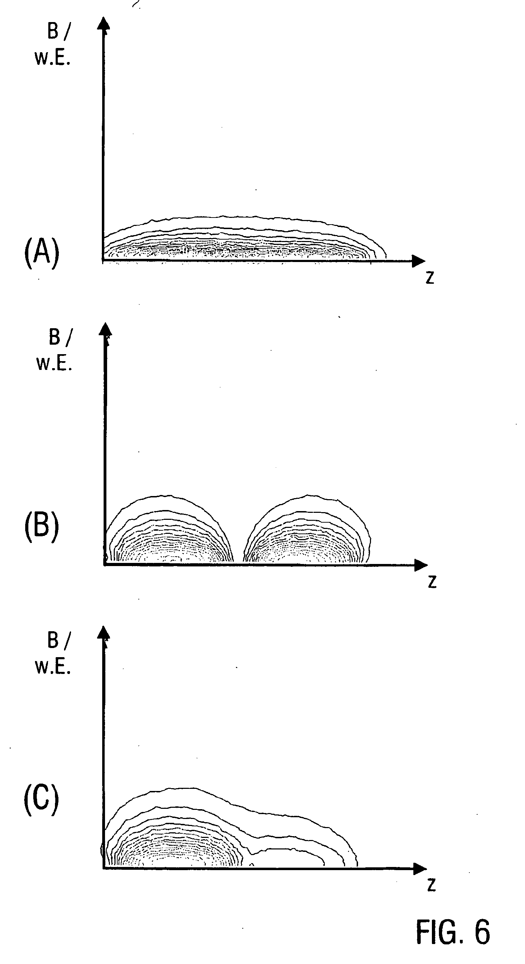

Mit der Leiterschleifen-Anordnung 20, deren Resonanzeigenschaften durch die Dimension der Leiterschleife 21, die Kondensatoren 23 und die Parallel- und Serien-Kondensatoren 24, 25 bestimmt werden, wird ein Zusatzfeld erzeugt, das sich dem Hauptfeld des Streifenleiter-Resonators 10 vektoriell überlagert, so dass die Empfindlichkeit der vollständigen Antenne gebildet wird. Das veränderte Gesamtfeld und die daraus resultierende Antennenempfindlichkeit hängen von den Amplituden und Phasen an den Anschlüssen 26 der Resonatoren 10, 20, der geometrischen Lage beider Resonatoren relativ zueinander und von der Lage der zugehörigen Resonanzfrequenzen ab. Die Bildung des veränderten Gesamtfeldes ist beispielhaft in Figur 6 für eine abgewandelte Ausführungsform der Erfindung gezeigt.

Es sei an dieser Stelle angemerkt, dass man das Feldprofil alternativ oder zusätzlich durch weitere Maßnahmen, wie z. B. eine schaltbare teilweise Bedämpfung oder Verstimmung der einzelnen Resonatoren weiter verändern kann, um z. B. einen verbesserte räumliche HF-Homogenität beim Senden einzustellen.

In Figur 2 ist beispielhaft eine Ausführungsform einer erfindungsgemäßen Antennenanordnung 200 schematisch illustriert. Die Antennenanordnung 200 umfasst vier Antennen 100, die gemäß Figur 1 jeweils mit einem Streifenleiter-Resonator 10 und einer Leiterschleifen-Anordnung 20 aufgebaut sind. Die Antennen 100 sind auf einem gemeinsamen Träger 210 aus einem dielektrischen Material, z. B. Kunststoff, angebracht.

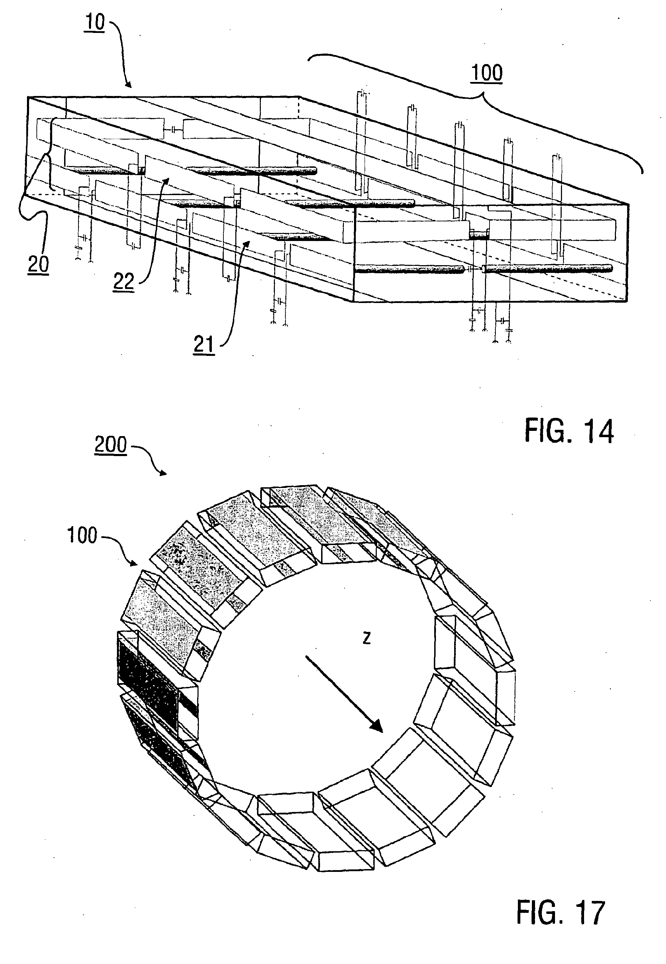

Es wird betont, dass das in Figur 2 gezeigte Ausführungsbeispiel lediglich illustrativen Zwecken dient. Die Antennenanordnung 200 kann weniger (mindestens zwei) Antennen 100 oder mehr (z. B. gemäß der derzeitig praktisch verfügbaren Anzahl von Empfangskanälen bis zu 128 Antennen) oder darüber hinaus, insbesondere bis zu 1024 Antennen 100 umfassen. Die Antennen 100 müssen nicht wie dargestellt in einer Richtung senkrecht zur Längsrichtung der Streifenleiter nebeneinander angeordnet sein. Alternativ können die Antennen versetzt und/oder mit veränderten Abständen angeordnet sein. Des Weiteren kann die Antennenanordnung 200 (wie auch jede einzelnen Antenne 100) an die Form des Objekts, z. B. an anatomische Formen eines untersuchten Körperteils, angepasst sein. In diesem Fall ist der Träger 210 der Antennen gekrümmt gebildet. Ein Beispiel mit einer dreidimensionalen Antennenanordnung ist in Figur 17 illustriert.

In Figur 3 ist eine bevorzugte Ausführungsform eines erfindungsgemäßen MR-Geräts 300, das mindestens eine erfindungsgemäße Antenne oder Antennenanordnung umfasst, in schematischer Schnittansicht illustriert. Das MR-Gerät 300 ist, abgesehen von der Antenne oder Antennenanordnung, im Wesentlichen wie ein herkömmliches MR-Gerät aufgebaut. Es umfasst eine Hauptspule 310, die zur Erzeugung des statischen Magnetfeldes B₀ in z-Richtung eingerichtet ist, die Sende-/Empfangsspule 320, die durch mindestens eine erfindungsgemäße Antenne 100 oder Antennenanordnung gebildet wird, eine Gradientenspule 330, die zur Ortskodierung der Signale vorgesehen ist, einen Probenträger 340, der zur Aufnahme des zu untersuchenden Objekts 1 (z. B. ein menschlicher Körper oder Teile von diesem) eingerichtet ist, und eine Steuereinheit 350, deren Komponenten insbesondere zur Steuerung, Energieversorgung, Datenaufnahme und Bedienung des MR-Geräts 300 vorgesehen sind. Die Steuereinheit 350 umfasst insbesondere einen Hochfrequenz-Empfänger 60 und einen Hochfrequenz-Sender 70, eine Stromversorgung 80 und einen Steuerrechner 90, der mit weiteren Peripheriegeräten, z. B. einem Datenspeicher, einem Sichtgerät und einer Bedienungseinheit verbunden ist. Ein Umschalter 51 ist zum Umschalten der Sende-/Empfangsspule 320 (Antenne 100) zwischen dem Sende- und Empfangsbetrieb vorgesehen. Der Umschalter 51 kann auch mehrfach, z.B. für die Antenne 100 und die Leiterschleifen-Anordnung 20 bzw. für Antennenanordnungen 200 vorgesehen sein.

Die erfindungsgemäße Antenne 100 ist im MR-Gerät 300 so angeordnet, dass die Längsrichtung der Streifenleiter 11 des Streifenleiter-Resonators (z. B. Figur 1C) in z-Richtung, d. h. parallel zum statischen Magnetfeld B₀ verläuft. Es ist allerdings nicht zwingend erforderlich, dass der Streifenleiter 11 parallel zur z-Richtung ausgerichtet ist. Alternativ kann die Antenne 100 verkippt sein. Dabei verringert sich zwar zwangsläufig die Spulenempfindlichkeit in der x-y-Ebene. Dies kann jedoch aus anatomischen Überlegungen oder unter dem Gesichtspunkt der Parallelbildgebung sinnvoll sein. Werden z. B. Antennen mit den Streifenleiter-Resonatoren 10 verkippt zum B₀-Feld, z. B. auf einem Zylindermantel, angeordnet und werden dann Bilder z.B. in der x-z-Ebene aufgenommen, so kommen in z-Richtung mehrere Streifenleiter-Resonatoren 10 zum Einsatz, was für die Beschleunigung der Bildaufnahme von Nutzen sein kann.

Erfindungsgemäß kann der Gradient des *B*₁-Feldes während der Experimente verändert und somit den experimentellen Wünschen angepasst werden, was z. B. mit schnellen Schaltdioden erfolgen kann.

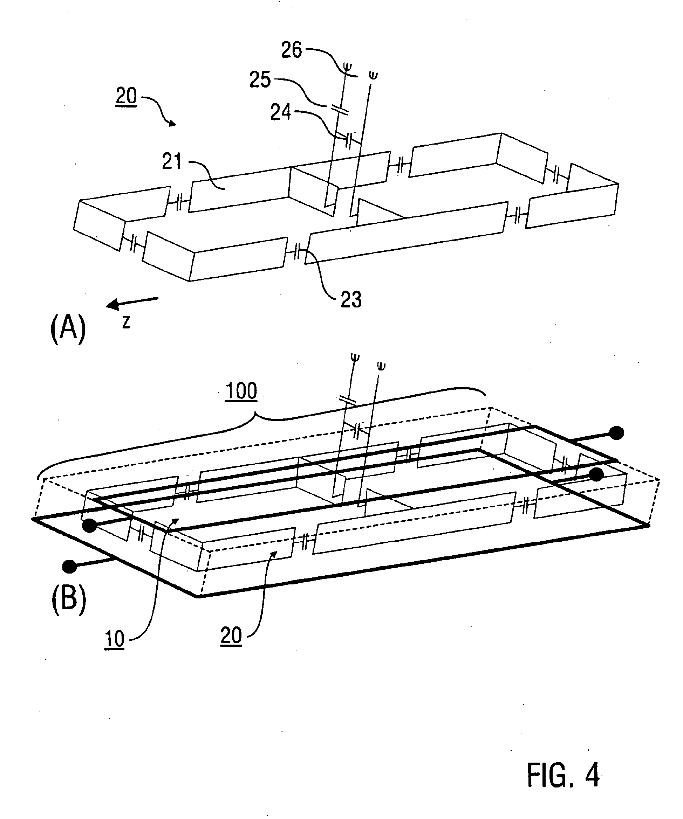

In Figur 4 ist der Aufbau einer weiteren Ausführungsform der erfindungsgemäßen Antenne 100 illustriert, die den Streifenleiter-Resonator 10 und die Leiterschleifen-Anordnung 20 umfasst. Der Streifenleiter-Resonator 10 ist so aufgebaut, wie dies oben unter Bezug auf Figur 1A beschrieben wurde. Die Leiterschleifen-Anordnung 20, die in Figur 4A einzeln gezeigt ist, hat die Form einer sog. "Ziffer-8-Spule", die auch als Leiterform mit drei Sprossen und zwei Holmen beschrieben werden kann.

Die erfindungsgemäß seitlich angebrachte Leiterschleifen-Anordnung 20 (Figur 4A) mit drei das Dielektrikum vom Streifenleiter-Resonator durchdringenden Leiterabschnitten ist zur Einspeisung und Abstimmung in dem mittleren Leiterabschnitt kapazitiv überbrückt und ähnelt in seiner geometrischen Form der Ziffer "8". Neben dieser aus zwei Rechtecken erzeugten (technisch sehr einfach zu realisierenden) Form kann es bei bestimmten Anwendungen auch günstig sein, wenn man die Leiterschleifen-Anordnung aus zwei Ellipsen oder Polygonzügen aufbaut. Es ist nicht unbedingt erforderlich, dass die beiden Teile der Leiterschleifen-Anordnung 20 in dieser Ausführungsform in ihren Maßen identisch sind. Auch durch Variation der Geometrie der beiden Teile kann man die gewünschte Anpassung des Sende/Empfangs-Profils herbeiführen.

Zur Homogenisierung der Phase und zur Abstimmung auf die gewünschte Resonanzfrequenz sind mehrere Kondensatoren 23 in die erfindungsgemäß vorgeschlagene Leiterschleifen-Anordnung 20 eingebracht. Dabei ist es nicht zwingend erforderlich, dass an allen gezeigten Positionen Kondensatoren angebracht sind. Bei bestimmten Anwendungen der Erfindung kann ein durch Laufzeiteffekte unsymmetrisches oder deformiertes Feldprofil wünschenswert für die Parallelbildgebung, für HF-Shimming oder für parallele Sendetechniken sein. Dabei kann zur Erhöhung der Flexibilität eine von außen schaltbare Anordnung über PIN-Dioden vorteilhaft sein.

Die komplette veränderbare Antenne ist in dieser Ausführungsform in Figur 4B dargestellt. Es sei an dieser Stelle angemerkt, dass das Feldprofil durch die in Bezug auf die Figuren 1 oder 2 genannten Maßnahmen modifiziert sein kann. Es kann insbesondere vorteilhaft sein, wenn mehrere Leiterschleifen-Anordnungen mit ggf. in Längsrichtung des Leiterstreifen-Resonators reduzierten Abmessungen in dieser Richtung mit Abstand oder überlappt angeordnet werden. Gegebenenfalls kann auch die in Figur 1 gezeigte Leiterschleifen-Anordnung 20 alternierend mit der in Figur 4 gezeigten Leiterschleifen-Anordnung angeordnet werden. Dadurch können ggf. eine bessere HF-Homogenität im Sendefall und höhere Beschleunigungsfaktoren bei der Parallelbildgebung erreicht werden.

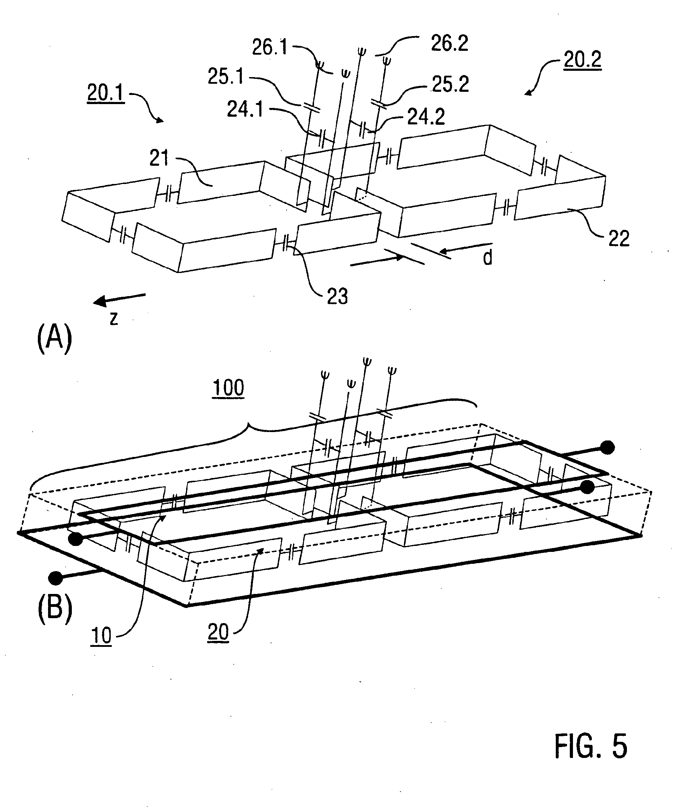

Figur 5 zeigt eine Variante der Erfindung, bei der die Antenne 100 zwei Leiterschleifen-Anordnungen 20.1, 20.2 enthält. Jede der Leiterschleifen-Anordnungen 20.1, 20.2 hat die Gestalt des in Figur 1 gezeigten Ausführungsbeispiels. Die Leiterschleifen-Anordnungen 20.1, 20.2 sind mit einem gegenseitigen Abstand d nebeneinander angeordnet. Der Abstand d ist bspw. im Bereich von 1 mm bis zu mehreren cm, z. B. 1 cm oder maximal der zehnfachen Länge der Einzelschleife gewählt. Zwischen den Leiterschleifen können noch zusätzliche Entkoppelkondensatoren und/oder Entkoppelnetzwerke angeordnet sein.

Jede der Leiterschleifen-Anordnungen 20.1, 20.2 ist über ein eigenes Netzwerk von Parallel- und Seriell-Kondensatoren 24.1, 25.1 und 24.2, 25.2 mit den getrennten Anschlüssen 26.1 und 26.2 verbunden. Vorteilhafterweise wird damit eine im Vergleich zur Ausführungsform gemäß Figur 4 erhöhte Flexibilität bei der Einstellung der Antennenempfindlichkeit erzielt. Jede der Leiterschleifen-Anordnungen 20.1, 20.2 kann unabhängig von der jeweils anderen Leiterschleifen-Anordnung angesteuert werden.

In Figur 6 ist beispielhaft gezeigt, wie erfindungsgemäß das Feldprofil des Streifenleiter-Resonators (Figur 6A) und das Feldprofil der Leiterschleifen-Anordnung (Figur 6B), die hier eine Anordnung gemäß Figur 4 oder 5 umfasst, zu einem überlagerten Feldprofil der Antenne 100 (Figur 6C) addiert werden. Das überlagerte Feldprofil in Figur 6C illustriert die in z-Richtung strukturierte Antennenempfindlichkeit, wenn z. B. an einer der Leiterschleifen-Anordnungen eine zusätzliche Sende-Amplitude eingestellt wird.

Es sei angemerkt, dass das Feldprofil durch die in den anderen Ausführungsbeispielen genannten Maßnahmen weiter modifizieren werden kann. Es kann vorteilhaft sein, dass noch weitere Leiterschleifen-Anordnungen mit reduzierten Abmessungen in Richtung der Längsausdehnung des Streifenleiter-Resonators angeordnet werden.

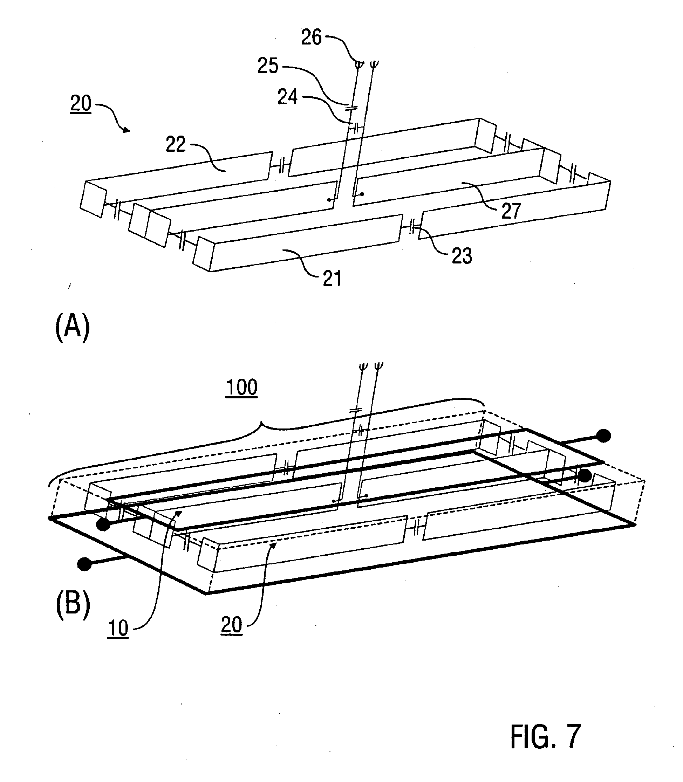

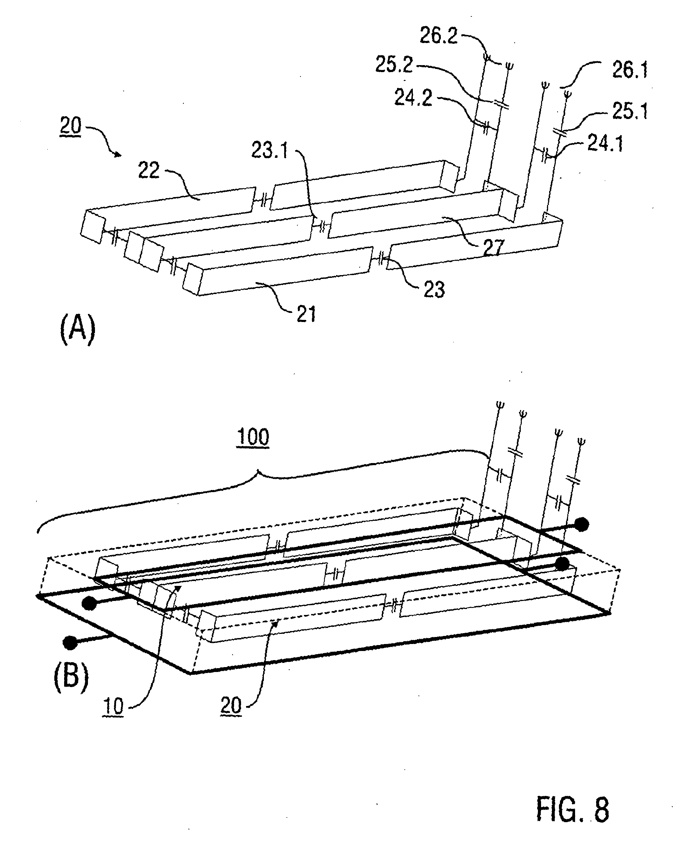

Bei den in den Figuren 7 und 8 gezeigten Ausführungsformen der Antenne 100 ist ebenfalls der Streifenleiter-Resonator 10 gemäß Figur 1A vorgesehen. Die Leiterschleifen-Anordnung 20 ist jedoch in Richtung der Längsausdehnung des Streifenleiter-Resonators 10 durch einen weiteren Leiter 27 unterteilt. Der mittlere Leiterabschnitt 27 in Fig. 7 ist durch ein Netzwerk mit den Parallel- und Serien-Kondenatoren 24, 25 und die Anschlüsse 26 unterbrochen. Ersatzweise (Fig. 8) kann der Leiter 27 durch einen weiteren Kondensator 23.1, der wie die Kondensatoren 23 z. B. gemäß Figur 1 gebildet ist, unterbrochen sein. Bei geeigneter Dimensionierung des Entkoppelkondensators 23.1 werden zwei entkoppelte Teilresonatoren gebildet. Die Teilresonatoren können über die Anschlüsse 26 oder andere separate Speisepunkte unabhängig voneinander zur Steuerung der Antenne 100 verwendet werden.

Die Ausführungsformen gemäß den Figuren 7B und 8B ähneln einer gedrehten "Ziffer-8-Spule". Durch die Drehung ist vorteilhafterweise auch das zwischen den beiden Teilresonatoren der Leiterschleifen-Anordnung 20 erzeugte Feld NMR-aktiv. Die Ausführungsformen gemäß den Figuren 7B und 8B können insbesondere benutzt werden, um das Feld des Streifenleiter-Resonators 10 teilweise oder nahezu vollständig auszulöschen, umzukehren oder einer Verstärkung mit einem vorbestimmten Verstärkungsfaktor zu unterziehen.

Neben der in den Figuren 7A und 8A mit zwei Rechtecken gezeigten, technisch sehr einfach zu realisierenden Form kann es vorteilhaft sein, wenn die Leiterschleifen-Anordnung in dieser Ausführungsform aus Ellipsen oder Polygonzügen aufgebaut ist. Es ist ebenfalls nicht unbedingt erforderlich, dass die beiden Teile der Leiterschleifen-Anordnung identische Maße aufweisen. Auch durch Variation der Geometrie der beiden Teile kann die gewünschte Anpassung des Sende/EmpfangsProfils der Antenne bereitgestellt werden.

Zur Homogenisierung und Abstimmung sind auch bei dieser Ausführungsform eine Reihe von Kondensatoren 23 in der erfindungsgemäß vorgeschlagenen Leiterschleifen-Anordnung 20 eingebracht. Dabei ist es nicht zwingend erforderlich, dass an allen gezeigten Positionen Kondensatoren angebracht werden. In manchen Fällen kann ein durch Laufzeiteffekte unsymmetrisches oder deformiertes Feldprofil durchaus wünschenswert für die Parallelbildgebung, für HF-Shimming oder für parallele Sendetechniken sein.

Der gemäß Figur 8 im mittleren Leiterabschnitt 27 angeordnete Kondensator 23.1 kann auch zur Entkopplung zwischen den beiden Teilen der Leiterschleifen-Anordnung 20 genutzt werden. Bei einer Phasenverschiebung von 180° zwischen den beiden Speisepunkten (Anschlüsse 26.1, 26.2) der beiden Teile der Leiterschleifen-Anordnung wird die in Figur 7 realisierte Variante bereitgestellt. Bei anderen Phasenverschiebungen kann man abweichende Feldprofile einstellen.

Die komplette veränderbare Antenne 100 ist den Figuren 7B bzw. 8B dargestellt. Die Änderung des Empfindlichkeitsprofils erfolgt bei diesen Ausführungsformen hauptsächlich in einer Ebene senkrecht zur Längsausdehnung des Streifenleiter-Resonators (z. B. x-y-Ebene). Werden der Streifenleiter-Resonator 10 und die Leiterschleifen-Anordnung 20 gemeinsam angesteuert, so kann das Feldprofil der Antenne 100 in der gewünschten Weise deformiert werden. Dabei müssen die Sendephasen und -amplituden nicht notwendigerweise gleich sein.

Figur 9 zeigt eine Variante der Erfindung, bei der die Antenne 100 als Leiterschleifen-Anordnung 20 eine einfache Leiterschleife 21 enthält, die in Bezug auf das isolierende Dielektrikum 13 teilweise seitlich auf der Oberfläche des Dielektrikums 13 und teilweise das Dielektrikum 13 durchdringend angebracht ist (Figur 9A). Der Streifenleiter-Resonator 10 ist einseitig kurzgeschlossen. Figur 9B zeigt beispielhaft ein mit der Antenne 100 erzeugtes Feldprofil.

Das Dielektrikum 13 (Isolierkörper) besteht zur einfachen Realisierung aus drei PP-Platten (Dicke 5 mm; Breite 70 mm; Länge 300 mm). Er ist hier der Einfachheit halber als ein Stück gezeichnet. Die mittlere Platte ist in ein 270 mm langes Stück und zwei 15 mm lange Stücke unterteilt. Auf die Seitenflächen des 270 mm langen, mittleren Stückes wird etwa 12 µm dicke Kupferfolie mit einer Breite von 5 mm (entspricht der Dicke der Platte) geklebt. Dieser Leiter wird an den gezeigten Stellen in einer Breite von etwa 5 mm unterbrochen und mit Kondensatoren überbrückt. Bei einem konkreten Ausführungsbeispiel wurde als Kapazität ein Wert von 20,9 pF zur Nutzung der Streifenleiter-Anordnung bei 123,1 MHz (Lamor-Frequenz für 1H bei 2,9 T) gefunden. Diesen Wert realisiert man beispielsweise durch antimagnetische Chip-Kondensatoren mit einer Kapazität von 22 pF und an einer oder ggf. auch an mehreren Stellen als Parallelschaltung eines antimagnetischen Chip-Kondensators (15 pF) mit einen antimagnetischem variablen Kondensator (Drehkondensator, Rohrtrimmer oder ähnliches) mit einem variablen Kapazitätsbereich von 0.5 pF bis 10 pF. Der Einstellwert für den variablen Abstimm-Kondensator 24 beträgt z. B. 27,4 pF. Der Fachmann weiß, dass es sich bei diesen Angaben für die Kondensatoren um Richtwerte handelt und auch andere Kombinationen zur Resonanz bei 123,1 MHz führen und dass man durch größere Kapazitäten die Resonanzfrequenz zu tieferen und durch kleinere Kapazitäten zu höheren Frequenzen schieben kann.

Mit der obigen Dimensionierung wird diese Anordnung im einfachsten Fall mit einem antimagnetischen variablen Serienkondensator 25 mit einem Einstellwert von 39,9 pF auf 50 Ohm angepasst. Auch hierbei handelt es sich um einen Richtwert, der durch Beladungseffekte usw. beeinflusst wird. Diese Anordnung wird an den beiden Stirnseiten wieder durch die vorher abgesägten 15 mm langen PP-Endstücke auf eine Gesamtlänge von 300 mm gebracht.

Auf diese Anordnung werden unten und oben die beiden anderen PP-Platten aufgelegt, so dass das in Figur 9A als ein Stück gezeichnete PP-Dielektrikum 13 mit der Leiterschleifen-Anordnung gebildet wird. Auf diesen nunmehr 15 mm dicken Isolierkörper wird auf der Unterseite selbstklebende, 50 mm breite und 12 µm dicke Cu-Folie in einer Länge von 300 mm geklebt. Es wird betont, dass diese Maße Beispielwerte sind, wobei auch andere Werte möglich sind. Der untere, zur Fokussierung des Feldes vom Streifenleiter-Resonator 10 in Richtung zur Probe (nicht dargestellt), vorzugsweise breitere Streifen 12 wird oft als Erde ("ground-Leiter") bezeichnet. Auf der Deckfläche ist aus der 10 µm dicken Cu-Folie ein schmalerer Leiter 11 (z. B. 15 mm breit) in einer Länge von 300 mm aufgebracht. Am Ende (in Figur 9A hinten) ist ein Kurzschluss zur Terminierung vorgesehen, der ebenfalls aus 50 mm breiter und 12 µm dicker, selbstklebender Cu-Folie hergestellt ist. Zwischen der Leiterschleifen-Anordnung 20 und dem Streifenleiter-Resonator 10 wird eine Entkopplung von ca. 50 dB erreicht.

Zur elektrischen Isolation wird die nach diesem Verfahren hergestellte veränderbare Antenne 100 mit Schrumpfschlauch, z. B. aus Polyolefin (farblos) umhüllt.

Figur 9B zeigt beispielhaft das mit der Antenne 100 erzeugte B1-Feld, wenn die Leiterschleifen-Anordnung 20 mit einer relativen Amplitude 3 W und einer relativen Phase von -90° und der Streifenleiter-Resonator 10 mit einer relativen Amplitude von 1 W und einer relativen Phase von 0° angesteuert werden.

Figur 10 zeigt eine weitere Antenne (keine Ausführungsform der Erfindung), bei der die Antenne 100 als Leiterschleifen-Anordnung 20 mehrere Leiterschleifen 21.1, 21.2, 21.3 enthält, die durch parallele, stabförmige Leiter 27.1 im isolierenden Dielektrikum 13 gebildet werden (Figur 10A). Der Streifenleiter-Resonator 10 ist einseitig kurzgeschlossen. Figur 10B zeigt beispielhaft ein mit der Antenne 100 erzeugtes Feldprofil.

Bei der Fertigung der steuerbaren Antenne 100 wird ebenfalls von 3 Platten aus PP ausgegangen (5 mm dick, 7 cm breit und 30 cm lang). In eine der drei Platten werden symmetrisch zur Mitte in einem Abstand von 4,75 cm (bzw. 14,25 cm) je zwei Schlitze (etwa 1 mm breit) bis etwa zur Mitte der Platte gefräst. Diese Schlitze dienen zur Aufnahme der vier in der Mitte unterbrochenen Drähte zur Bildung der stabförmigen Leiter. Die Drähte (Cu, Cu versilbert oder ähnliche Materialien mit hoher Leitfähigkeit für die HF) haben einen Durchmesser von etwa 1 mm. Die beiden äußeren Leiterstäbe 27.1, 27.4 sind in der Mitte mit 48,3 pF kapazitiv überbrückt, während sich für die beiden mittleren Leiterstäbe 27.2, 27.3 ein Wert von 47.2 pF als optimal für eine Entkopplung zwischen den Teilschleifen 21.1, 21.2, 21.3 der Leiterschleifen-Anordnung 20 erwiesen hat.

Die Hochfrequenzleistung für diese komplexe Leiterschleifen-Anordnung 20 wird über einen oder mehrere seitlich an einer Unterbrechung der Leiterschleife angeordnete Abstimmkondensatoren 24, z. B. 24,6 pF eingespeist. Im dargestellten Beispiel kann die Hochfrequenzleistung an drei Stellen angelegt werden, um das Verhalten der Leiterschleifen-Anordnung 20 zu beeinflussen. Zum Anpassen an das Kabel werden variable Kondensatoren 25, z. B. 5 bis 25 pF verwendet, die auf einem Wert von z. B. 9.9 pF eingestellt sind. Die Unterbrechungen auf der gegenüberliegenden Seite der Leiterschleife werden mit 24,7 pF kapazitiv überbrückt.

Es wird angemerkt, dass die hier angegebenen Kapazitätswerte durch variable Kondensatoren, bzw. durch eine Kombination aus einem variablen Kondensator und einem Festkondensator eingestellt werden können. Hierzu können z. B. Trimm-Kondensatoren (2 bis 50 pF) verwendet werden. Bei den angegebenen Beispielen handelt es sich um Richtwerte, die bei Bedarf variiert werden können.

Auf die so präparierte mittlere Platte werden oben und unten je eine weitere PP-Platte aufgelegt (30 cm lang, 7 cm breit und 5 mm dick). Auf die Außenflächen dieses als Stapel gefertigten Isolierkörpers wird der Streifenleiter-Resonator 10 aus etwa 12 µm dicker selbstklebender Cu-Folie aufgeklebt. Der obere Leiter 11 ist 15 mm breit und 30 cm lang, während die Kurzschluss Terminierung am Ende des Dielektrikums 13 und der untere Leiter 12 aus 5 cm breiter und 12 µm dicker selbstklebender Cu-Folie gefertigt werden. An dem zum Kurzschluss gegenüberliegenden offenen Ende ist ein Abstimm-Kondensator 24, ca. 3 pF angeordnet. Im einfachsten Fall wird der Streifenleiter-Resonator mit einem Anpassungs-Kondensator 25, etwa 3 pF angeschlossen.

Die einzelnen Leiterschleifen 21.1, 21.2, 21.3 der Leiterschleifen-Anordnung 20 sind untereinander mit etwa 20 dB entkoppelt, während die Entkopplung zum Streifenleiter-Resonator etwa 40 dB ist.

Figur 10B zeigt beispielhaft das mit der Antenne 100 erzeugte B1-Feld, wenn alle Leiterschleifen 21.1, 21.2, 21.3 der Leiterschleifen-Anordnung 20 gegenphasig angesteuert sind.

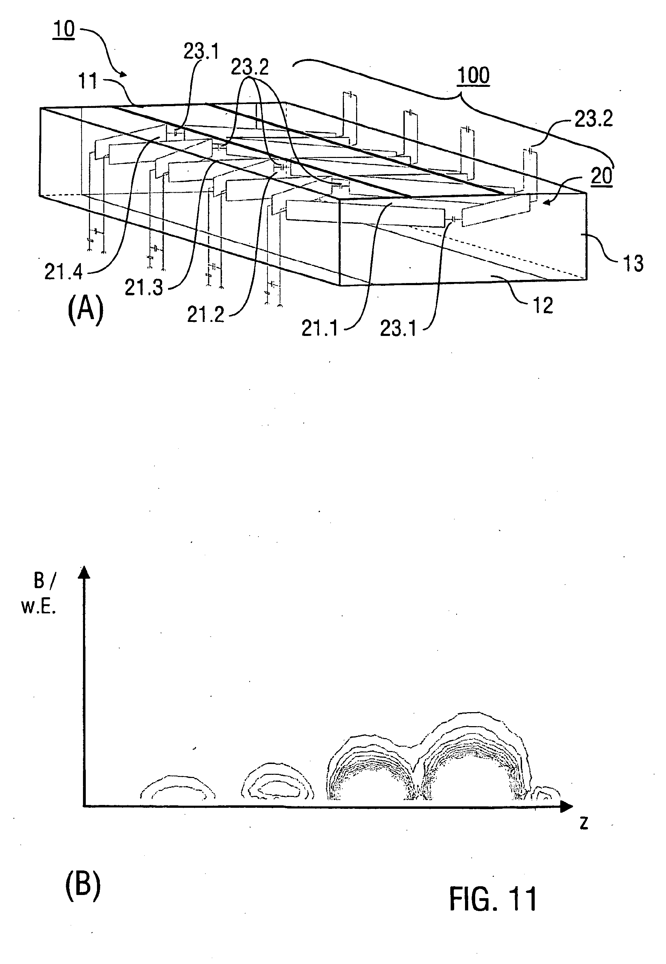

Figur 11 zeigt eine weitere Variante der Erfindung, bei der die Antenne 100 als Leiterschleifen-Anordnung 20 vier rhombusförmige Leiterschleifen 21.1, 21.2, 21.3, 21.4 enthält. Zur Fertigung der steuerbaren Antenne 100 (Figur 11A) werden ebenfalls drei PP-Platten (5 mm dick, 7 cm breit und 30 cm lang) verwendet. In eine der drei Platten werden symmetrisch zur Mitte Vierecke mit einer Kantenlänge von ca. 5cm herausgefräst. Diese Durchbrüche werden an ihren inneren Schnittflächen zur Bildung der Leiterschleifen mit leitfähiger Folie beklebt. Die Unterbrechungen an der rechten Ecke des rechten Vierecks und an der linken Ecke des linken Vierecks sind mit Kondensatoren 23.1 überbrückt, während die Stellen, wo die Leiterschleifen in der Mitte der Platte aneinander grenzen, mit Kapazitäten 23.2 von 350 pF überbrückt sind. Die beiden äußeren Leiterschleifen 21.1, 21.4 sind mit 26,5 pF abgestimmt und mit 4,2 pF angepasst. Gegenüber dem Abstimmkondensator befindet sich noch je ein Kondensator mit einem Wert von 75,3 pF. Die beiden mittleren Leiterschleifen 21.2, 21.3 sind mit 22 pF abgestimmt und mit 3,5 pF angepasst. Gegenüber dem Abstimmkondensator befindet sich ein Kondensator von 73 pF. Der Streifenleiter-Resonator 10 ist mit 2,9 pF abgestimmt und mit 3,2 pF angepasst. Es soll angemerkt werden, dass die hier angegebenen Kapazitätswerte durch variable Kondensatoren bzw. durch eine Kombination aus einem variablen Kondensator und einem Festkondensator eingestellt werden können. Bei den angegebenen Beispielen handelt es sich um Richtwerte, die gegebenenfalls modifiziert werden können.

Nachdem die Cu-Streifen und Kapazitäten angebracht sind, wird der Rest der Durchbrüche wieder mit PP der Dicke von 5 mm aufgefüllt, um eine Störung des Feldes im Dielektrikum 13 gering zu halten, bzw. zu vermeiden. Auf diese so präparierte mittlere Platte werden oben und unten je eine weitere PP-Platte aufgelegt (30 cm lang, 7 cm breit und 5 mm dick). Auf die Außenflächen dieses als Stapel gefertigten Dielektrikums 13 (Isolierkörper) wird der Streifenleiter-Resonator 10 aus etwa 12 µm dicker, selbstklebender Cu-Folie aufgeklebt. Der obere Leiter 11 ist 15 mm breit und 30 cm lang, während der Kurzschluss-Terminierungs-Leiter und der untere Leiter 12 aus 5 cm breiter und 12 µm dicker, selbstklebender Cu-Folie gefertigt sind. An dem zum Kurzschluss gegenüberliegenden offenen Ende ist ein Abstimm-Kondensator (ca. 3 pF) angeordnet.

Im einfachsten Fall wird der Streifenleiter-Resonator 10 mit einem Anpassungs-Kondensator (etwa 3 pF) angeschlossen. Die einzelnen Leiterschleifen der Leiterschleifen-Anordnung 20 sind untereinander mit etwa 20 dB entkoppelt, während die Entkopplung zum Streifenleiter-Resonator etwa 40 dB ist.

Figur 11B zeigt beispielhaft das mit der Antenne 100 erzeugte B1-Feld, wenn alle Leiterschleifen 21.1, 21.2, 21.3, 21.4 der Leiterschleifen-Anordnung 20 mit verschiedenen Amplituden und Phasen angesteuert sind.

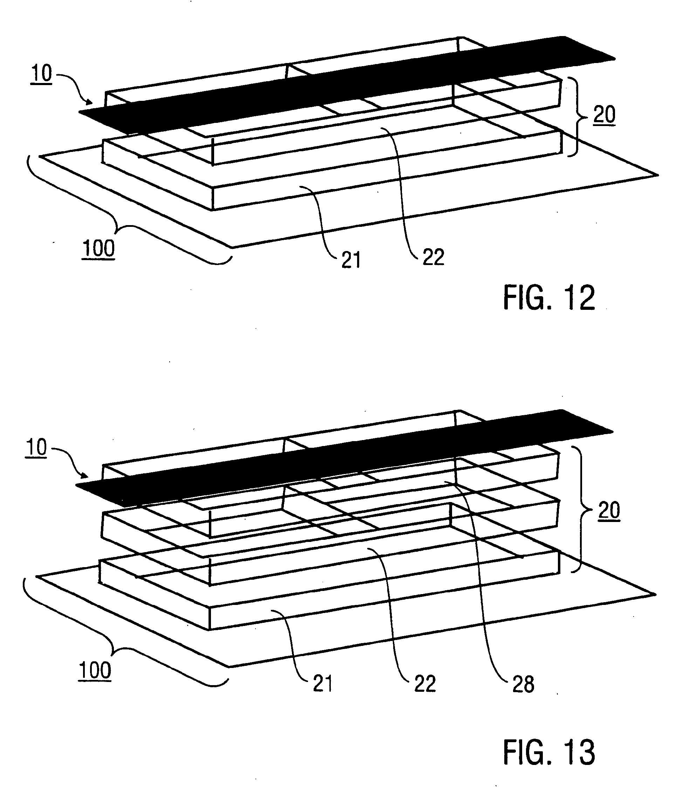

Die Figuren 12 und 13 illustrieren schematisch weitere Ausführungsformen der erfindungsgemäßen Antenne 100, bei denen die Leiterschleifen-Anordnung 20 mehrere Leiterschleifen 21, 22 (und 28) umfasst. Die Leiterschleifen 21, 22, 28 bilden einen Stapelaufbau im Dielektrikum 13 des Streifenleiter-Resonators 10. Die Form der einzelnen Leiterschleifen kann in Abhängigkeit von den Anforderungen der gewählten Erfindung gewählt werden. Es können z. B. einfache Schleifen (entsprechend Figuren 1B, 9) oder "Ziffer-8-Anordnungen" (gemäß Figur 4A) oder Kombinationen aus diesen vorgesehen sein.

Angemerkt sei, dass die Bildung der Leiterschleifen-Anordnung mit mehreren Leiterschleifen in mehreren Richtungen erweitert werden kann (z. B. mit mehreren parallelen Leiterabschnitten).

Gemäß der Figur 12 sind bspw. zwei Leiterschleifen 21, 22 übereinander angeordnet. Auch für diese Variante der Erfindung wird ein einfacher Streifenleiter-Resonator 10 gemäß Figur 1A verwendet. Die erfindungsgemäß seitlich überstehende Leiterschleifen-Anordnung 20 besteht aus zwei Leiterschleifen 21, 22. Bei exakt symmetrischem Aufbau der Anordnung von Figur 12 sind der Streifenleiter-Resonator 10 und die beiden übereinander liegenden Leiterschleifen 21, 22 entkoppelt, so dass die Phasen und Amplituden an den drei Speisepunkten des Streifenleiter-Resonators 10 und der Leiterschleifen 21, 22 vorteilhafterweise unabhängig voneinander gewählt werden können. Somit ergeben sich günstige Bedingungen für die Parallelbildgebung, für HF-Shimming oder für parallele Sendetechniken.

Es sei an dieser Stelle angemerkt, dass das Feldprofil modifiziert werden kann, indem mehrere Leiterschleifen-Anordnungen nach dem Vorbild von Figur 12 mit in Längsrichtung des Leiterstreifen-Resonators reduzierten Abmessungen in dieser Richtung mit Abstand oder überlappt angeordnet werden. Vorteilhafterweise können die Leiterschleifen alternierend gestapelt mit und ohne Abstand in Längsrichtung des Streifenleiter-Resonators 10 angeordnet sein. Dadurch werden ein besseres HF-Shimming im Sendefall und höhere Beschleunigungsfaktoren bei der Parallelbildgebung erreicht.

Das in Figur 12 gezeigte Stapelprinzip kann bei Bedarf z. B. gemäß Figur 13 erweitert werden. Gegebenenfalls können Maßnahmen zur Entkopplung zwischen übereinanderliegenden Leiterschleifen-Anordnungen gemäß dem Stand der Technik getroffen werden. Es können insbesondere drei Leiterschleifen 21, 22, 28 übereinander angeordnet sein. Gemäß weiteren Abwandlungen können mehr als drei, z. B. fünf oder mehr übereinander angeordnete Leiterschleifen einen Stapel bilden. Die Leiterschleifen können wie dargestellt im Stapel relativ zueinander fluchtend ausgerichtet oder relativ zueinander versetzt angeordnet sein.

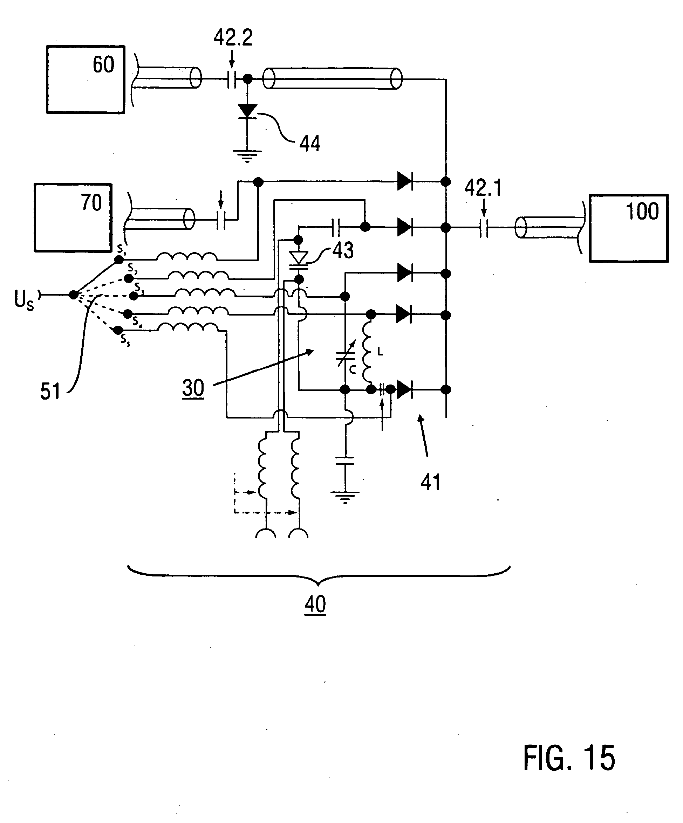

Figur 15 zeigt beispielhaft eine Ausführungsform einer Schalteinrichtung 40, die zur Verbindung der Antenne 100 mit dem Empfänger 60 oder dem Sender 70 des MR-Geräts (siehe Figur 3) vorgesehen ist. Die Schalteinrichtung 40 ist jeweils für die Anwendung am Streifenleiter-Resonator 10 und an den Leiterschleifen-Anordnung(en) 20 vorgesehen. Die Schalteinrichtung 40 weist eine Gruppe von PIN-Dioden 41 auf, die über einen Trennkondensator 42.1 und eine Koaxialleitung mit einem der Anschlüsse (26, siehe z. B. Figur 1B) der Antenne 100 verbunden sind. Die Schalteinrichtung 40 weist des Weiteren einen Umschalter 51 auf, mit dem eine positive Schaltspannung Us (z. B. +5 V) wahlweise auf eine der PIN-Dioden 41 geschaltet werden kann.

Bei +5 V fließt ein ausreichend hoher Strom durch die entsprechende Diode, und sie ist niederohmig. Sie schaltet das entsprechende Bauelement an. Der Einfachheit halber wird bei dieser Darstellung der hochohmige Zustand schon bei 0 Volt angenommen. Hier ist in der Praxis allerdings die Diode nur unzuverlässig gesperrt. Deshalb legt man für den sicheren Sperrzustand -30 V an.

Wenn am Umschalter 51 (Schalter für die unterschiedlichen Betriebszustände, T/R-Umschalter) für die PIN-Dioden-Vorspannung eine negative Vorspannung (vereinfachend auch Null) angelegt ist und der Schalter auf den Positionen S1-S5 steht, so ist die Antenne 100 mit dem Vorverstärker des Empfängers 60 verbunden. In diesem Fall sind die jeweiligen sich im Strompfad befindenden PIN-Dioden geöffnet. Im Empfangsweg können zusätzlich zu dem weiteren Trennkondensator 42.2 noch weitere Elemente, wie z. B. ein Phasenschieber vorgesehen sein. Wird hingegen eine umgekehrte Spannung (z. B. +5 V) als Vorspannung am Umschalter 51 angelegt, so wird eine der Voreinstellungen S1 bis S5 des Umschalters 51 wirksam. In der Schalterstellung S1 wird der Sender mit der Antenne verbunden (klassischer Sendefall).

In den Schalterstellungen S2 bis S5 nutzt man die Kopplung zwischen einer mit dem HF-Sender verbundenen Antenne 10 mit Leiterschleifen-Anordnung 20 zu anderen Antennen 10 mit Leiterschleifen-Anordnung 20, oder innerhalb einer Antenne 10 zur Leiterschleifen-Anordnung 20 und beeinflusst deren Stärke. Dadurch wird die Amplitude des erzeugten Magnetfeldes so beeinflusst, dass das gewünschte Gesamtfeld, z. B. entsprechend vorbestimmter Vorgaben, gebildet werden kann. In der Schalterstellung S2 ist eine Varactor-Diode 43 eingeschaltet, mit der bei geeigneter Dimensionierung der Abstimmzustand der Antenne 100 bzw. der Leiterschleifen-Anordnung 20 ferngesteuert werden kann. Der variable Kondensator bewirkt in der Schalterstellung S3 ebenfalls eine Veränderung des Abstimmzustandes ohne Fernsteuerung. In Schalterstellung S4 wird eine Induktivität parallel zum Abstimmkondensator geschaltet. Damit kann die Induktivität zusammen mit dem Kondensator 24 (siehe Figur 16) des Streifenleiter-Resonators 10 oder eines entsprechenden Kondensators einer Leiterschleifen-Anordnung einen Parallelschwingkreis bilden, so dass sich der Streifenleiter-Resonator 10 oder eine Leiterschleifen-Anordnung öffnet. In der Schalterstellung S5 wird der Parallel-Kondensator des Streifenleiter-Resonators 10 oder ein entsprechender Kondensator der Leiterschleifen-Anordnung HF-bezogen kurzgeschlossen. In allen Schalterstellungen S2 bis S5 ist der Vorverstärker des Empfängers 60 von der Schalteinrichtung 40 getrennt, da der Vorverstärker am Eingang über eine weitere PIN-Diode 44 kurzgeschlossen und das Ä/4-Kabel am anderen Ende hochohmig ist. Vorteilhafterweise kann der Umschalter 51 in an sich bekannter Weise als elektronischer Schalter ausgeführt werden, so dass die gesamte Schalteinrichtung 40 ferngesteuert werden kann.

In Figur 16 sind schematisch verschiedene Varianten der Ansteuerung und Terminierung des Streifenleiter-Resonators 10 mit den ersten und zweiten Leiterstreifen 11, 12 illustriert. Figur 16B zeigt verschiedene Terminierungsvarianten, die an den Anschlüssen C/D (siehe auch Figur 1A) vorgesehen sein können. Die Terminierungsmöglichkeiten umfassen insbesondere eine kapazitive Terminierung, eine induktive Terminierung, einen Kurzschluss, eine offene Terminierung, eine Terminierung mit einem Widerstand, der ungleich dem Wellenwiderstand des Streifenleiter-Resonators 10 ist, und eine Terminierung mit einem Schwingkreis (Tankkreis) in Reihe mit einem Serienkondensator.

Die Figuren 16C und 16D illustrieren zwei Möglichkeiten zur Einspeisung der HF-Spannung über die Abstimmeinrichtung 30 an die Anschlüsse A/B (entsprechend den Anschlüssen 26, siehe Figur 1). Gemäß Figur 16C ist eine Impedanzanpassung mit einem so genannten Π-Kreis (Collins-Filter) vorgesehen, während Figur 16D das Netzwerk aus Parallel- und Serien-Kondensatoren 24, 25 zur Abstimmung und Anpassung des Streifenleiter-Resonators 10 zeigt.

In Figur 17 ist ein zweidimensionales Array 200 dargestellt, das aus erfindungsgemäßen Antennen 100, insbesondere gemäß mindestens einer der oben beschriebenen Ausführungsformen aufgebaut sein kann. Dabei soll ausdrücklich darauf hingewiesen werden, dass es für bestimmte Untersuchungen günstig sein kann, veränderbare Antennen 100 aus verschiedenen Ausführungsformen alternierend oder in vorbestimmter Reihenfolge einzusetzen. In Figur 17 sind die Antennen 100 in Richtung einer Zylinderachse (z-Richtung) ausgerichtet, die z. B. mit der Richtung des statischen Magnetfelds B₀ des MR-Geräts übereinstimmt. Es kann,vorteilhaft sein, dass die Antennen 100 oder auch nur die Streifenleiter-Resonatoren auf einem Zylindermantel oder anders geformten anatomisch angepassten Formkörper in einem gewissen Winkel zur Richtung des statischen Magnetfelds (z. B. längs einer Helix) angeordnet sind. In diesen Fall erreicht man eine zusätzliche Strukturierung des Sende-/Empfangsprofils in Richtung des statischen Magnetfelds.

Es ist auch möglich, einzelne Segmente der erfindungsgemäßen veränderbaren Antenne mittels bekannter Techniken auf unterschiedliche Larmor-Frequenzen abzustimmen und ggf. den Abstimmzustand mittels schneller Schaltdioden schaltbar zu gestalten. Es ist aber auch denkbar für die Abstimmung der Resonatoren, Netzwerke einzusetzen, die beispielsweise aus einem Parallelschwingkreis (Tank) und einem in Reihe geschalteten Kondensator bestehen und die gleichzeitige Abstimmung auf mehrere Larmor-Frequenzen ermöglichen. Gegebenenfalls können die erfindungsgemäß beschriebenen veränderbaren Antennen auch in Quadratur betrieben werden. Erfindungsgemäß ist auch die Anordnung einer oder mehrerer veränderbarer Antennen in anatomisch angepasster Form, z. B. domähnlich für Untersuchungen des Kopfes oder auf dem Mantel eines Zylinders zur Untersuchung der Extremitäten oder in Form von zwei mehr oder weniger ebenen Flächen zur Untersuchung im Körperstammbereich.

Die in der vorstehenden Beschreibung, den Zeichnungen und den Ansprüchen offenbarten Merkmale der Erfindung können einzeln oder auch in Kombination für die Verwirklichung der Erfindung in ihren verschiedenen Ausgestaltungen von Bedeutung sein, soweit die Ausgestaltungen vom Wortlaut des Anspruchs 1 umfasst sind.

## Patentansprüche

1. Antenne (100) für ein Magnetresonanzgerät, die eine vorbestimmte Empfindlichkeit aufweist und für eine Anregung und/oder Erfassung einer Magnetresonanz in einem zu untersuchenden Objekt eingerichtet ist, umfassend:
- einen Streifenleiter-Resonator (10), der zwei Leiterstreifen (11, 12) aufweist, und
- eine resonante Leiterschleifen-Anordnung (20), die auf mindestens eine Larmor-Frequenz abgestimmt ist, an den Streifenleiter-Resonator (10) angrenzend angeordnet ist und mindestens eine geschlossene Leiterschleife (21, 22, 28) bildet, deren Leiter mit mindestens einem Kondensator (23) unterbrochen ist, wobei
- der Leiter der mindestens einen Leiterschleife (21, 22, 28) mit einer schichtförmigen Querschnittsform gebildet ist, und
- die Empfindlichkeit der Antenne (100) am Ort des zu untersuchenden Objekts durch überlagerte Empfindlichkeitsprofile des Streifenleiter-Resonators (10) und der Leiterschleifen-Anordnung (20) gebildet wird, wobei
- die Leiterstreifen des Streifenleiter-Resonator (10) einen ersten planaren Leiterstreifen (11) und einen zweiten planaren Leiterstreifen (12) aufweisen, die zueinander parallel und durch ein Dielektrikum (13) getrennt angeordnet sind, wobei
- die mindestens eine geschlossene Leiterschleife (21, 22, 28) in einer Ebene gebildet ist, die parallel zu den planaren Leiterstreifen (11, 12) ist, wobei
- der schichtförmige Leiter der mindestens einen Leiterschleife (21, 22, 28) innerhalb und/oder außerhalb des Dielektrikums (13) des Streifenleiter-Resonators (10) und an den Streifenleiter-Resonator (10) angrenzend angeordnet ist, **dadurch gekennzeichnet, dass** der schichtförmige Leiter relativ zu den zueinander parallelen Leiterstreifen des Streifenleiter-Resonators orthogonal ausgerichtet ist, so dass die Kapazität zwischen der Leiterschleifen-Anordnung (20) und dem Streifenleiter-Resonator (10) minimiert wird.

2. Antenne gemäß Anspruch 1, bei der
- die mindestens eine Leiterschleife (21, 22, 28) einen Ring oder ein Vieleck umfasst.

3. Antenne gemäß mindestens einem der vorhergehenden Ansprüche, bei der
- die mindestens eine Leiterschleife (21, 22, 28) mehrere Ringe oder Vielecke umfasst.

4. Antenne gemäß Anspruch 3, bei der die Ringe oder Vielecke der mindestens einen Leiterschleife (21, 22, 28)
- sich gegenseitig überlappen oder mit einem gegenseitigen Abstand angeordnet sind, und/oder
- eine Schleifenform mit mindestens zwei Löchern aufweisen.

5. Antenne gemäß mindestens einem der vorhergehenden Ansprüche, bei der
- mindestens eine weitere Leiterschleife (21, 22, 28) vorgesehen ist, wobei eine der Leiterschleifen (21) eine Schleifenform mit mindestens zwei Löchern aufweist und die weitere Leiterschleife (22) einen Ring oder ein Vieleck umfasst.

6. Antenne gemäß mindestens einem der vorhergehenden Ansprüche, bei der
- mindestens eine weitere Leiterschleife (21, 22, 28) vorgesehen ist, wobei die Leiterschleifen (21, 22, 28) als Stapel übereinander angeordnet sind.

7. Antenne gemäß mindestens einem der vorhergehenden Ansprüche, die umfasst:
- eine Abstimmeinrichtung (30), die zur Abstimmung der Antenne (100) auf mindestens eine Larmor-Frequenz eingerichtet ist.

8. Antenne gemäß Anspruch 7, bei der
- die Abstimmeinrichtung (30) zur Abstimmung verschiedener Teile der Antenne (100) auf unterschiedliche Larmor-Frequenzen eingerichtet ist.

9. Antenne gemäß einem der Ansprüche 7 bis 8, bei der
- der mindestens eine Kondensator (23) Teil der Abstimmeinrichtung (30) ist.

10. Antenne gemäß mindestens einem der vorhergehenden Ansprüche, die umfasst:
- eine Schalteinrichtung (40), mit der die Empfindlichkeit der Antenne (100) veränderlich ist.

11. Antenne gemäß Anspruch 10, bei der
- die Schalteinrichtung (40) PIN-Dioden (41) aufweist.

12. Antenne gemäß mindestens einem der vorhergehenden Ansprüche, bei der
- der Streifenleiter-Resonator (10) und die Steuervorrichtung (20) jeweils einen Umschalter (51) zur Verbindung mit einem Empfänger (60) und einem Sender (70) des Magnetresonanzgerätes (300) aufweist.

13. Antennenanordnung (200), die eine Vielzahl von Antennen (100) gemäß mindestens einem der vorhergehenden Ansprüche umfasst.

14. Antennenanordnung gemäß Anspruch 13, bei der
- die Antennen (100) auf einer gekrümmten Fläche angeordnet sind.

15. Antennenanordnung gemäß Anspruch 14, bei der
- die Antennen (100) auf der gekrümmten Fläche helixförmig angeordnet sind.

16. Magnetresonanzgerät (300), das mindestens eine Antenne (100) oder Antennenanordnung (200) gemäß mindestens einem der vorhergehenden Ansprüche umfasst.

17. Magnetresonanzgerät (300) gemäß Anspruch 16, das umfasst:
- einen Empfänger (60) und einen Sender (70), wobei
- der Streifenleiter-Resonator (10) und die Leiterschleifen-Anordnung (20) der Antenne über Umschalter (51) mit dem Empfänger und dem Sender verbunden sind.

18. Verfahren zur Magnetresonanz-Bildgebung oder Magnetresonanz-Spektroskopie, mit den Schritten:
- Anregung und/oder Erfassung einer Magnetresonanz in einem zu untersuchenden Objekt mit einer Antenne (100) oder einer Antennenanordnung (200) gemäß mindestens einem der Ansprüche 1 bis 15.

19. Verfahren gemäß Anspruch 18, bei dem
- die Antenne (100) als Sende-Antenne, Empfangs-Antenne oder als Sende-Empfangs-Antenne oder im alternierenden Betrieb oder für eine sendeseitige oder empfangsseitige Parallelbildgebungs-Technik verwendet wird.

## Claims

1. An antenna (100) for a magnetic resonance device which has a predetermined sensitivity and is arranged for exciting and/or detecting a magnetic resonance in an object to be examined, comprising:
- a strip line resonator (10) which comprises two strip lines (11, 12), and
- a resonant conductor loop arrangement (20) which is tuned to at least one Larmor frequency and which is disposed adjacent to the strip line resonator (10) and forms at least one closed conductor loop (21, 22, 28) the conductors of which being interrupted by at least one capacitor (23), wherein
- the conductor of the at least one conductor loop (21, 22, 28) is formed with a layer-shaped cross-sectional form, and
- the sensitivity of the antenna (100) at the position of the object to be examined is formed by superimposed sensitivity profiles of the strip line resonator (10) and the conductor loop arrangement (20), wherein
- the strip lines of the strip line resonator (10) have a first planar strip line (11) and a second planar strip line (12), which are arranged in parallel to each other and separated by a dielectric (13), wherein
- the at least one closed conductor loop (21, 22, 28) is formed in a plane, which is in parallel with the planar strip lines (11, 12), wherein
- the layer-shaped conductor of the at least one conductor loop (21, 22, 28) is arranged within and/or outside a dielectric (13) of the strip line resonator (10) and adjacent to the strip line resonator (10),
**characterised in that**
- the layer-shaped conductor is oriented orthogonally relative to the mutually parallel strip lines of the strip line resonator, so that the capacity between the conductor loop arrangement (20) and the strip line resonator (10) is minimized.

2. The antenna as claimed in claim 1, wherein
- the at least one conductor loop (21, 22, 28) comprises a ring or polygon.

3. The antenna as claimed in one of the preceding claims, wherein
- the at least one conductor loop (21, 22, 28) comprises multiple rings or polygons.

4. The antenna as claimed in claim 3, wherein the rings or polygons of the at least one conductor loop (21, 22, 28)
- overlap one another or are disposed at a mutual spaced interval, and/or
- comprise a loop form having at least two holes.

5. The antenna as claimed in at least one of the preceding claims, wherein
- at least one further conductor loop (21, 22, 28) is provided, wherein one of the conductor loops (21) comprises a loop form having at least two holes and the further conductor loop (22) comprises a ring or a polygon.

6. The antenna as claimed in at least one of the preceding claims, wherein
- at least one further conductor loop (21, 22, 28) is provided, wherein the conductor loops (21, 22, 28) are disposed one above the other.

7. The antenna as claimed in at least one of the preceding claims, comprising:
- a tuning device (30) which is arranged for tuning the antenna (100) to at least one Larmor frequency.

8. The antenna as claimed in claim 7, wherein
- the tuning device (30) is arranged for tuning various parts of the antenna (100) to different Larmor frequencies.

9. The antenna as claimed in any one of claims 7 to 8, wherein
- the at least one capacitor (23) is part of the tuning device (30).

10. The antenna as claimed in at least one of the preceding claims, comprising:
- a switching device (40), by means of which the sensitivity of the antenna (100) can be varied.

11. The antenna as claimed in claim 10, wherein
- the switching device (40) comprises PIN-diodes (41).

12. The antenna as claimed in at least one of the preceding claims, wherein
- the strip line resonator (10) and the control device (20) comprises in each case a change-over switch (51) for connecting to a receiver (60) and a transmitter (70) of the magnetic resonance device (300).

13. Antenna array (200) which comprises a plurality of antennas (100) as claimed in at least one of the preceding claims.

14. The antenna array as claimed in claim 13, wherein
- the antennas (100) are disposed on a curved surface.

15. The antenna array as claimed in claim 14, wherein
- the antennas (100) are disposed on the curved surface in a helical manner.

16. A magnetic resonance device (300) which comprises at least one antenna (100) or antenna array (200) as claimed in at least one of the preceding claims.

17. The magnetic resonance device (300) as claimed in claim 16, comprising:
- a receiver (60) and a transmitter (70), wherein
- the strip line resonator (10) and the conductor loop arrangement (20) of the antenna are connected to the receiver and the transmitter via change-over switches (51).

18. A method for magnetic resonance imaging or magnetic resonance spectroscopy, including the steps of:
- exciting and/or detecting a magnetic resonance in an object, which is to be examined, with an antenna (100) or an antenna array (200) as claimed in at least one of claims 1 to 15.

19. The method as claimed in claim 18, wherein
- the antenna (100) is used as a transmitting antenna, receiving antenna or as a transmitting-receiving antenna or in alternating operation or for a transmission-side or reception side parallel imaging technique or a combination of both methods.

## Revendications

1. Antenne (100) pour un appareil à résonance magnétique présentant une sensibilité prédéterminée et prévu pour exciter et/ou détecter une résonance magnétique dans un objet à examiner, comprenant :
- un résonateur à guide d'ondes à rubans (10) présentant deux cadres de montage à ruban (11, 12), et
- un dispositif résonant à boucle conductrice (20), réglé sur au moins une fréquence de Larmor, monté de manière adjacente au résonateur à guide d'ondes à rubans (10) et formant au moins une boucle conductrice (21, 22, 28) qui est interrompue par au moins un condensateur (23),
- le guide d'ondes de la ou des boucles conductrices (21, 22, 28) étant prévu avec une section stratifiée, et
- la sensibilité de l'antenne (100) étant formée à l'emplacement de l'objet à examiner par des profils de sensibilité superposés du résonateur à guide d'ondes à rubans (10) et du dispositif à boucle conductrice (20),
- les cadres de montage à ruban du résonateur à guide d'ondes à rubans (10) présentant un premier cadre de montage à ruban planaire (11) et un deuxième cadre de montage à ruban planaire (12), disposés parallèlement l'un à l'autre et séparés par un diélectrique (13),
- la ou les boucles conductrices fermées (21, 22, 28) étant formées sur un plan parallèle aux cadres de montage à ruban planaire (11, 12),
- le guide d'ondes stratifié de la ou des boucles conductrices (21, 22, 28) étant monté à l'intérieur et/ou à l'extérieur du diélectrique (13) du résonateur à guide d'ondes à rubans (10) et adjacent au résonateur à guide d'ondes à rubans (10),
**caractérisée en ce que** le guide d'ondes stratifié est orienté orthogonalement par rapport aux cadres de montage à ruban parallèles entre eux du résonateur à guide d'ondes à rubans, de manière à minimiser la capacité entre le dispositif à boucle conductrice (20) et le résonateur à guide d'ondes à rubans (10).

2. Antenne selon la revendication 1, où
- la ou les boucle conductrices (21, 22, 28) comprennent un anneau ou un polygone.

3. Antenne selon au moins une des revendications précédentes, où
- la ou les boucles conductrices (21, 22, 28) comprennent plusieurs anneaux ou polygones.

4. Antenne selon la revendication 3, où les anneaux ou les polygones de la ou des boucles conductrices (21, 22, 28)
- se chevauchent mutuellement ou sont disposés avec un espacement entre eux, et/ou
- présentent une forme en boucle avec au moins deux trous.

5. Antenne selon au moins une des revendications précédentes, où
- au moins une autre boucle conductrice (21, 22, 28) est prévue, une des boucles conductrices (21) présentant une forme en boucle avec au moins deux trous et l'autre boucle conductrice (22) comprenant un anneau ou un polygone.

6. Antenne selon au moins une des revendications précédentes, où
- au moins une autre boucle conductrice (21, 22, 28) est prévue, les boucles conductrices (21, 22, 28) étant superposées l'une à l'autre en pile.

7. Antenne selon au moins une des revendications précédentes, comprenant :
- un dispositif de réglage (30), destiné au réglage de l'antenne (100) sur au moins une fréquence de Larmor.

8. Antenne selon la revendication 7, où
- le dispositif de réglage (30) est prévu pour le réglage de différentes parties de l'antenne (100) sur différentes fréquences de Larmor.

9. Antenne selon l'une des revendications 7 et 8, où
- le ou les condensateurs (23) font partie du dispositif de réglage (30).

10. Antenne selon au moins une des revendications précédentes, comprenant :
- un dispositif de commutation (40) variable avec la sensibilité de l'antenne (100).

11. Antenne selon la revendication 10, où
- le dispositif de commutation (40) comprend des diodes PIN (41).

12. Antenne selon au moins une des revendications précédentes, où
- le résonateur à guide d'ondes à rubans (10) et le dispositif de commande (20) comprennent chacun un commutateur (51) pour la connexion avec un récepteur (60) et un émetteur (70) de l'appareil à résonance magnétique (300).

13. Dispositif à antennes (200) comprenant une pluralité d'antennes (100) selon au moins une des revendications précédentes.

14. Dispositif à antennes selon la revendication 13, où
- les antennes (100) sont disposées sur une surface courbe.

15. Dispositif à antennes selon la revendication 14, où
- les antennes (100) sont disposées en forme d'hélice sur la surface courbe.

16. Appareil à résonance magnétique (300), comprenant au moins une antenne (100) ou un dispositif à antennes (200) selon au moins une des revendications précédentes.

17. Appareil à résonance magnétique (300) selon la revendication 16, comprenant :
- un récepteur (60) et un émetteur (70),
- le résonateur à guide d'ondes à rubans (10) et le dispositif à boucle conductrice (20) de l'antenne étant reliés au récepteur et à l'émetteur via le commutateur (51).

18. Procédé d'imagerie à résonance magnétique ou de spectroscopie à résonance magnétique, comprenant les étapes suivantes :
- excitation et/ou détection d'une résonance magnétique dans un objet à examiner avec une antenne (100) ou un dispositif à antennes (200) selon au moins une des revendications 1 à 15.

19. Procédé selon la revendication 18, où
- l'antenne (100) est utilisée comme antenne d'émission, antenne de réception ou comme antenne d'émission/de réception, ou en fonctionnement alterné pour une 'technique d'imagerie parallèle côté émetteur ou côté récepteur.
